(19) Europäisches Patentamt / European Patent Office / Office européen des brevets

(11) **EP 4 560 918 A1**

(12) **EUROPEAN PATENT APPLICATION**
published in accordance with Art. 153(4) EPC

(43) Date of publication:
**28.05.2025 Bulletin 2025/22**

(21) Application number: 23842813.0

(22) Date of filing: 03.07.2023

(51) International Patent Classification (IPC):
$H03H\ 11/40^{(2006.01)}$    $H01Q\ 3/36^{(2006.01)}$
$H03C\ 3/00^{(2006.01)}$    $H03H\ 11/16^{(2006.01)}$
$H03H\ 11/20^{(2006.01)}$

(52) Cooperative Patent Classification (CPC):
H01Q 3/36; H03C 3/00; H03H 11/16; H03H 11/20; H03H 11/40

(86) International application number:
**PCT/JP2023/024674**

(87) International publication number:
**WO 2024/018888 (25.01.2024 Gazette 2024/04)**

| | |
|---|---|
| (84) Designated Contracting States:<br>**AL AT BE BG CH CY CZ DE DK EE ES FI FR GB GR HR HU IE IS IT LI LT LU LV MC ME MK MT NL NO PL PT RO RS SE SI SK SM TR**<br>Designated Extension States:<br>**BA**<br>Designated Validation States:<br>**KH MA MD TN**<br><br>(30) Priority: 20.07.2022 JP 2022115645<br>         21.09.2022 JP 2022150343 | (71) Applicant: **The Ritsumeikan Trust**<br>**Kyoto-shi, Kyoto 604-8520 (JP)**<br><br>(72) Inventor: **NOSAKA, Hideyuki**<br>**Kusatsu-shi, Shiga 525-8577 (JP)**<br><br>(74) Representative: **Prinz & Partner mbB**<br>**Patent- und Rechtsanwälte**<br>**Rundfunkplatz 2**<br>**80335 München (DE)** |

(54) **SIGNAL GENERATION CIRCUIT**

(57) An N-tap resistor network circuit (11) is provided with a plurality of first resistors and a plurality of first taps, and generates a control voltage having one of a plurality of predetermined voltage values by selecting one of the plurality of first taps in accordance with an inputted digital control signal. An M-tap resistor network circuit (12) is provided with a plurality of second resistors and a plurality of second taps, and generates a plurality of predetermined reference voltages at the plurality of second taps. Each of folding circuits (13, 14) generates an output signal based on differences between the control voltage and the plurality of reference voltages, the output signal having a signal level corresponding to a predetermined phase of a sine wave or a cosine wave.

FIG. 1

EP 4 560 918 A1

**Description**

TECHNICAL FIELD

The present disclosure relates to a signal generation circuit, a phase shifter, an array antenna apparatus, and a wireless communication apparatus.

BACKGROUND ART

For wireless communication systems of the fifth-generation mobile communication system or later (Beyond 5G), use of a high-frequency band, such as millimeter waves and terahertz waves, has been studied in order to increase communication capacity. Furthermore, in order to increase communication capacity, it is being studied to focus a beam of a radio wave on a communication counterpart using a phased array antenna apparatus. By using the phased array antenna apparatus, it is possible to perform, for example, beam forming (directing a beam in a specific direction), beam steering (directing a beam to a communication counterpart), and beam tracking (continuously directing a beam to a communication counterpart moving at high speed).

In order to implement the phased array antenna apparatus, phase shifters capable of arbitrarily controlling a phase of a local signal are required. For example, Patent Document 1 discloses a vector-synthesis analog phase shifter used for a communication apparatus and a radar apparatus.

CITATION LIST

PATENT DOCUMENTS

PATENT DOCUMENT 1: Japanese patent laid-open publication No. JP 2003-133906 A

SUMMARY OF INVENTION

TECHNICAL PROBLEM

Patent Document 1 discloses reading and setting gains and bias voltages from a storage device to four differential variable gain amplifiers, and combining output signals of the four differential variable gain amplifiers. However, a circuit size and power consumption are increased to store such gains and bias voltages and to process signals based on the gains and bias voltages. Therefore, it is required to shift a phase of a signal with a smaller circuit size and a smaller power consumption than the prior art.

In addition, the phase shifter is required to have certain tolerance to variations in a process, a voltage, and a temperature (PVT variations). In addition, the phase shifter may be required to be digitally controllable. In addition, the phase shifter may be required to have linear control characteristics with respect to a control signal.

An object of the present disclosure is to provide a signal generation circuit that generates a signal to be used to control a phase shifter, the signal generation circuit having a smaller circuit size and a smaller power consumption than the prior art, having tolerance to PVT variations, being digitally controllable, and having linear control characteristics with respect to a control signal. In addition, a further object of the present disclosure is to provide a phase shifter, an array antenna apparatus, and a wireless communication apparatus provided with such a signal generation circuit.

SOLUTION TO PROBLEM

A signal generation circuit of a first aspect of the present disclosure is provided with: a first resistor network circuit, a second resistor network circuit, and at least one folding circuit. The first resistor network circuit is provided with a plurality of first resistors and a plurality of first taps. The first resistor network circuit generates a control voltage having one of a plurality of predetermined voltage values by selecting one of the plurality of first taps in accordance with an inputted digital control signal. The second resistor network circuit is provided with a plurality of second resistors and a plurality of second taps. The second resistor network circuit generates a plurality of predetermined reference voltages at the plurality of second taps. The at least one folding circuit generates an output signal based on differences between the control voltage and the plurality of reference voltages, the output signal having a signal level corresponding to a predetermined phase of a sine wave or a cosine wave.

According to a signal generation circuit of a second aspect of the present disclosure, the signal generation circuit of the first aspect is further configured as follows. The signal generation circuit is provided with: a first folding circuit that generates a first output signal having a signal level corresponding to a predetermined phase of a sine wave; and a second folding circuit that generates a second output signal having a signal level corresponding to a predetermined phase of a cosine wave.

According to a signal generation circuit of a third aspect of the present disclosure, the signal generation circuit of the second aspect is further configured as follows. The first folding circuit is provided with: a first differential amplifier that compares the control voltage with a first reference voltage to generate a first differential output signal; a second differential amplifier that compares the control voltage with a second reference voltage higher than the first reference voltage to generate a second differential output signal; and a third differential amplifier that compares the control voltage with a third reference voltage higher than the second reference voltage to generate a third differential output signal. The second folding circuit is provided with: a fourth differential amplifier that compares the control voltage with a fourth reference voltage to generate a fourth differential output signal; a fifth differential amplifier that compares the control voltage with a fifth reference voltage higher than the fourth reference voltage to generate a fifth differential output signal; and a sixth differential amplifier that compares the control voltage with a sixth reference voltage higher than the fifth reference voltage to generate a sixth differential output signal. The first output signal is a sum of the first and third differential output signals and an inverted signal of the second differential output signal. The second output signal is a sum of the fourth and sixth differential output signals and an inverted signal of the fifth differential output signal.

According to a signal generation circuit of a fourth aspect of the present disclosure, the signal generation circuit of the third aspect is further configured as follows. Each of the first to sixth differential amplifiers is provided with a pair of bipolar transistors or a pair of field effect transistors.

According to a signal generation circuit of a fifth aspect of the present disclosure, the signal generation circuit of one of the first to fourth aspects is further configured as follows. The first resistor network circuit is further provided with a first constant current source connected to the plurality of first resistors.

According to a signal generation circuit of a sixth aspect of the present disclosure, the signal generation circuit of one of the first to fifth aspects is further configured as follows. The first resistor network circuit is further provided with voltage-divider resistors connected to an output terminal of the first resistor network circuit.

According to a signal generation circuit of a seventh aspect of the present disclosure, the signal generation circuit of the third aspect is further configured as follows. The second resistor network circuit is provided with voltage-divider resistors that generate the first to sixth reference voltages from a power supply voltage.

According to a signal generation circuit of an eighth aspect of the present disclosure, the signal generation circuit of the third aspect is further configured as follows. The second resistor network circuit is further provided with: first voltage-divider resistors that generates the first to third reference voltages from a power supply voltage; and second voltage-divider resistors that generates the fourth to sixth reference voltages from the power supply voltage.

According to a signal generation circuit of a ninth aspect of the present disclosure, the signal generation circuit of the third aspect is further configured as follows. The second resistor network circuit is further provided with: first voltage-divider resistors that generates the first to third reference voltages from a first power supply voltage; and second voltage-divider resistors that generates the fourth to sixth reference voltages from a second power supply voltage.

According to a signal generation circuit of a tenth aspect of the present disclosure, the signal generation circuit of one of the first to ninth aspects is further configured as follows. The second resistor network circuit is further provided with a second constant current source connected to the plurality of second resistors.

According to a signal generation circuit of an eleventh aspect of the present disclosure, the signal generation circuit of the first aspect is further configured as follows. The first and second resistor network circuits are connected to a common voltage source.

According to a signal generation circuit of a twelfth aspect of the present disclosure, the signal generation circuit of one of the first to eleventh aspects is further configured as follows. The first and second resistors have a same temperature coefficient to each other.

According to a signal generation circuit of a thirteenth aspect of the present disclosure, the signal generation circuit of one of the first to twelfth aspects is further configured as follows. The first and second resistor network circuits are implemented on one integrated circuit.

A phase sifter of a fourteenth aspect of the present disclosure is provided with: the signal generation circuit of one of the second to fourth, seventh to ninth aspects; a quadrature splitter that splits an input signal into an in-phase signal and a quadrature-phase signal; a first multiplier that multiplies the in-phase signal by the second output signal of the signal generation circuit to generate a first multiplication signal; a second multiplier that multiplies the quadrature-phase signal by the first output signal of the signal generation circuit to generate a second multiplication signal; and a combiner that combines the first multiplication signal and the second multiplication signal with each other.

According to a phase sifter of a fifteenth aspect of the present disclosure, the phase sifter of the fourteenth aspect is further configured as follows. The phase shifter is further provided with a low-pass filter that reduces signal components of the first and second output signals of the signal generation circuit, the signal components having frequencies higher than a predetermined frequency.

An array antenna apparatus of a sixteenth aspect of the present disclosure is provided with: a plurality of antenna elements; a plurality of third mixers; and a plurality of the phase shifters of the fourteenth or fifteenth aspect.

A wireless communication apparatus of a seventeenth aspect of the present disclosure is provided with: the array antenna apparatus of the sixteenth aspect; and a communication circuit.

A signal generation circuit of an 18th aspect of the present disclosure is provided with: a first resistor network circuit, a second resistor network circuit, at least one folding circuit, and a first impedance conversion circuit. The first resistor network circuit is provided with a plurality of first resistors and a plurality of first taps. The first resistor network circuit generates a control voltage having one of a plurality of predetermined voltage values by selecting one of the plurality of first taps in accordance with an inputted digital control signal. The second resistor network circuit is provided with a plurality of second resistors and a plurality of second taps. The second resistor network circuit generates a plurality of predetermined reference voltages at the plurality of second taps. The at least one folding circuit generates an output signal based on differences between the control voltage and the plurality of reference voltages, the output signal having a signal level corresponding to a predetermined phase of a sine wave or a cosine wave. The first impedance conversion circuit is provided between the first resistor network circuit and the at least one folding circuit. The first impedance conversion circuit has an input impedance higher than an impedance seen from the first resistor network circuit to the at least one folding circuit, and has an output impedance lower than an impedance seen from the at least one folding circuit to the first resistor network circuit.

According to a signal generation circuit of a 19th aspect of the present disclosure, the signal generation circuit of the 18th aspect is further configured as follows. The first impedance conversion circuit includes an emitter follower circuit, a source follower circuit, or a voltage follower circuit.

According to a signal generation circuit of a 20th aspect of the present disclosure, the signal generation circuit of the 18th aspect is further configured as follows. The first impedance conversion circuit includes a first buffer circuit and a second buffer circuit connected in parallel to each other.

According to a signal generation circuit of a 21st aspect of the present disclosure, the signal generation circuit of the 18th aspect is further configured as follows. The first impedance conversion circuit includes: a first buffer circuit; and a second buffer circuit cascaded subsequent to the first buffer circuit.

According to a signal generation circuit of a 22nd aspect of the present disclosure, the signal generation circuit of the 21st aspect is further configured as follows. The first impedance conversion circuit further includes a third buffer circuit connected in parallel to the second buffer circuit.

According to a signal generation circuit of a 23rd aspect of the present disclosure, the signal generation circuit of the 18th aspect is further configured as follows. The signal generation circuit is further provided with a second impedance conversion circuit provided between the second resistor network circuit and the at least one folding circuit. The second impedance conversion circuit has characteristics identical to characteristics of the first impedance conversion circuit, with respect to variations in at least one of a manufacturing process, a power supply voltage, and a temperature.

According to a signal generation circuit of a 24th aspect of the present disclosure, the signal generation circuit of one of the 18th to 23rd aspects is further configured as follows. The signal generation circuit is further provided with: a first folding circuit that generates a first output signal having a signal level corresponding to a predetermined phase of a sine wave; and a second folding circuit that generates a second output signal having a signal level corresponding to a predetermined phase of a cosine wave.

According to a signal generation circuit of a 25th aspect of the present disclosure, the signal generation circuit of one of the 18th to 24th aspects is further configured as follows. The first and second resistors have a same temperature coefficient to each other.

According to a signal generation circuit of a 26th aspect of the present disclosure, the signal generation circuit of one of the 18th to 25th aspects is further configured as follows. The first and second resistor network circuits are implemented on one integrated circuit.

A phase sifter of a 27th aspect of the present disclosure is provided with: the signal generation circuit of the 24th aspect; a quadrature splitter that splits an input signal into an in-phase signal and a quadrature-phase signal; a first multiplier that multiplies the in-phase signal by the second output signal of the signal generation circuit to generate a first multiplication signal; a second multiplier that multiplies the quadrature-phase signal by the first output signal of the signal generation circuit to generate a second multiplication signal; and a combiner that combines the first multiplication signal and the second multiplication signal with each other.

An array antenna apparatus of a 28th aspect of the present disclosure is provided with: a plurality of antenna elements; a plurality of third mixers; and a plurality of the phase shifters of the 27th aspect.

A wireless communication apparatus of a 29th aspect of the present disclosure is provided with: the array antenna apparatus of the 28th aspect; and a communication circuit.

ADVANTAGEOUS EFFECTS OF INVENTION

According to one aspect of the present disclosure, it is possible to provide a signal generation circuit having a smaller circuit size and a smaller power consumption than the prior art, having tolerance to PVT variations, being digitally controllable, and having linear control characteristics with respect to a control signal.

BRIEF DESCRIPTION OF DRAWINGS

Fig. 1 is a block diagram showing a configuration of a phase shifter 1 provided with a signal generation circuit 10 according to a first embodiment.

Fig. 2 is a circuit diagram showing a configuration of the signal generation circuit 10 of Fig. 1.

Fig. 3 is a circuit diagram showing an exemplary configuration of differential amplifiers 31 to 33 and 41 to 43 of Fig. 2.

Fig. 4 is a circuit diagram showing another exemplary configuration of the differential amplifiers 31 to 33 and 41 to 43 of Fig. 2.

Fig. 5 is a graph schematically showing operation characteristics of each of the differential amplifiers 31 to 33 and 41 to 43 of Fig. 2.

Fig. 6 is a graph schematically showing changes in operation characteristics in cases where different reference voltages Vr2 and Vr4 are set for a pair of the differential amplifiers 31 and 32 of Fig. 2.

Fig. 7 is a graph explaining that the pair of differential amplifiers 31 and 32 of Fig. 2 can generate a signal having a waveform similar to a sine wave.

Fig. 8 is a diagram explaining a relationship among a control voltage Vc(k), reference voltages Vr, and output signals Vsin(k) and Vcos(k) of Fig. 1.

Fig. 9 is a circuit diagram showing a configuration of an M-tap resistor network circuit 12A of a signal generation circuit according to a first variation of the first embodiment.

Fig. 10 is a circuit diagram showing a configuration of an M-tap resistor network circuit 12B of a signal generation circuit according to a second variation of the first embodiment.

Fig. 11 is a circuit diagram showing a configuration of an N-tap resistor network circuit 11C of a signal generation circuit according to a third variation of the first embodiment.

Fig. 12 is a circuit diagram showing a configuration of an M-tap resistor network circuit 12C of the signal generation circuit according to the third variation of the first embodiment.

Fig. 13 is a circuit diagram showing a configuration of an N-tap resistor network circuit 11D and an M-tap resistor network circuit 12D of a signal generation circuit according to a fourth variation of the first embodiment.

Fig. 14 is a circuit diagram showing a configuration of an N-tap resistor network circuit 11E of a signal generation circuit according to a fifth variation of the first embodiment.

Fig. 15 is a block diagram showing a configuration of a phase shifter 1F according to a sixth variation of the first embodiment.

Fig. 16 is a block diagram showing a configuration of a phase shifter 1G provided with a signal generation circuit 10G according to a second embodiment.

Fig. 17 is a circuit diagram showing a configuration of the signal generation circuit 10G of Fig. 16.

Fig. 18 is a diagram for explaining a delay occurring in the signal generation circuit 10 according to the first embodiment.

Fig. 19 is a circuit diagram showing a configuration of an impedance conversion circuit 15 of Fig. 16.

Fig. 20 is a circuit diagram showing a configuration of an impedance conversion circuit 15A of a signal generation circuit according to a first variation of the second embodiment.

Fig. 21 is a circuit diagram showing a configuration of an impedance conversion circuit 15B of a signal generation circuit according to a second variation of the second embodiment.

Fig. 22 is a circuit diagram showing a configuration of an impedance conversion circuit 15C of a signal generation circuit according to a third variation of the second embodiment.

Fig. 23 is a circuit diagram showing a configuration of an impedance conversion circuit 15D of a signal generation circuit according to a fourth variation of the second embodiment.

Fig. 24 is a circuit diagram showing a configuration of an impedance conversion circuit 15E of a signal generation circuit according to a fifth variation of the second embodiment.

Fig. 25 is a block diagram showing a configuration of a phase shifter 1H provided with a signal generation circuit 10H according to a sixth variation of the second embodiment.

Fig. 26 is a circuit diagram showing a configuration of the signal generation circuit 10H of Fig. 25.

Fig. 27 is a block diagram showing a configuration of a wireless communication apparatus 100 according to a third embodiment.

DESCRIPTION OF EMBODIMENTS

Hereinafter, with reference to the drawings, we will describe a signal generation circuit, a phase shifter, an array antenna apparatus, and a wireless communication apparatus according to embodiments of the present disclosure. The same reference signs denote the similar components throughout the drawings.

[FIRST EMBODIMENT]

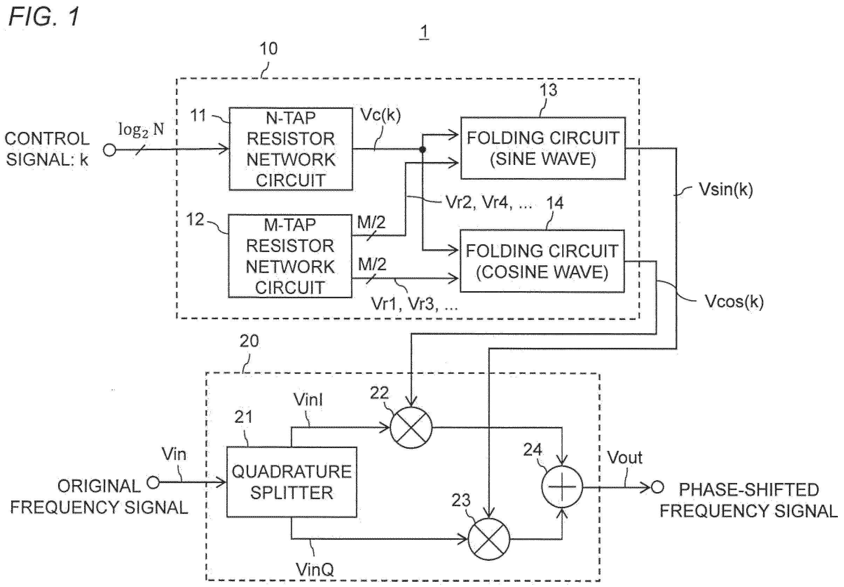

Fig. 1 is a block diagram showing a configuration of a phase shifter 1 provided with a signal generation circuit 10 according to a first embodiment. The phase shifter 1 is provided with the signal generation circuit 10 and a quadrature modulation circuit 20.

The signal generation circuit 10 is provided with an N-tap resistor network circuit 11, an M-tap resistor network circuit 12, and folding circuits 13 and 14. The N-tap resistor network circuit 11 is provided with a plurality of resistors and a plurality of N taps, and generates a control voltage Vc(k) having one of N predetermined voltage values by selecting one of the N taps in accordance with an inputted digital control signal k. The digital control signal k takes any value from 1 to N. The digital control signal k has a size of $\log_2 N$ bits. The M-tap resistor network circuit 12 is provided with a plurality of resistors and a plurality of M taps, and generates M predetermined reference voltages Vr1, ... , VrM at the M taps. The folding circuit 13 generates an output signal Vsin(k) bases on differences between the control voltage Vc(k) and the reference voltages Vr1, ... , VrM, the output signal Vsin(k) having a signal level corresponding to a predetermined phase of a sine wave. The folding circuit 14 generates an output signal Vcos(k) based on differences between the control voltage Vc(k) and the reference voltages Vr1, ... , VrM, the output signal Vcos(k) having a signal level corresponding to a predetermined phase of a cosine wave.

The quadrature modulation circuit 20 is provided with a quadrature splitter 21, multipliers 22 and 23, and a combiner 24. The quadrature splitter 21 splits an inputted original frequency signal Vin, to an I-component signal VinI and a Q-component signal VinQ. The multiplier 22 multiplies the I-component signal VinI by the signal Vcos(k) outputted from the folding circuit 14. The multiplier 23 multiplies the Q-component signal VinQ by the signal Vsin(k) outputted from the folding circuit 13. When each of the multipliers 22 and 23 is provided with two analog signals, it outputs a product of the two analog signals. Each of the multipliers 22 and 23 may be, for example, a four-quadrant multiplier or a variable gain amplifier. The combiner 24 combines the output signals of the multipliers 22 and 23 with each other, and outputs a phase-shifted frequency signal Vout.

Here, an operation principle of the quadrature modulation circuit 20 will be described. The original frequency signal Vin is expressed, as a sine wave having an angular frequency $\omega$, by Vin = sin($\omega t$). Furthermore, the following signals Vsin(k) and Vcos(k) are inputted from the signal generation circuit 10.

[Mathematical Expression 1]

$$Vsin(k) = \sin\left(k\frac{M-1}{2N}\pi\right)$$

[Mathematical Expression 2]

$$Vcos(k) = \cos\left(k\frac{M-1}{2N}\pi\right)$$

The quadrature splitter 21 generates two signals VinI = sin($\omega t$) and VinQ = cos($\omega t$) having phases shifted by 90 degrees. Next, the multipliers 22 and 23 multiply the signals VinI and VinQ by the signals Vcos(k) and Vsin(k) inputted from the signal generation circuit 10, respectively. The combiner 24 combines the output signals of the multipliers 22 and 23 with each other, and outputs the phase-shifted frequency signal Vout. Therefore, the phase-shifted frequency signal Vout is expressed as follows.

[Mathematical Expression 3]

$$Vout = VinI \cdot Vcos(k) + VinQ \cdot Vsin(k)$$

$$= \sin(\omega t) \cos\left(k\frac{M-1}{2N}\pi\right) + \cos(\omega t) \sin\left(k\frac{M-1}{2N}\pi\right)$$

$$= \sin\left(\omega t + k\frac{M-1}{2N}\pi\right)$$

Comparing the original frequency signal Vin with the phase-shifted frequency signal Vout, it can be seen that the phase shifter 1 generates an output signal having a phase shift proportional to the value of the digital control signal k.

The signal generation circuit 10 operates as a control circuit for the quadrature modulation circuit 20, and controls the phase shift of the signal Vin in the quadrature modulation circuit 20.

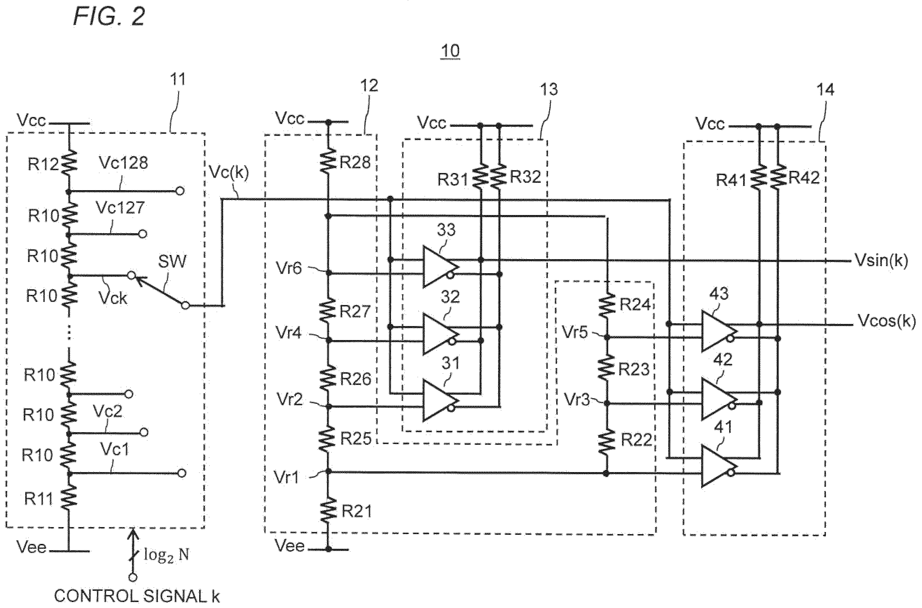

Fig. 2 is a circuit diagram showing a configuration of the signal generation circuit 10 of Fig. 1.

The N-tap resistor network circuit 11 is provided with a plurality of resistors R10, R11, and R12, the plurality of N taps, and a switch SW. The plurality of resistors R10, R11, and R12 are connected in series between a terminal of a positive power supply voltage Vcc and a terminal of a negative power supply voltage Vee. Fig. 2 shows a case of N = 128. Predetermined voltage values Vc1, ... , Vc128 different from each other occur at the N taps among the resistors R10, R11, and R12. The plurality of resistors R10 have the same resistance with each other. In this case, voltage differences among the voltage values Vc1, ... , Vc128 are equal to each other. The switch SW selects one of the N taps in accordance with the digital control signal k, and outputs the corresponding voltage value Vck as the control voltage Vc(k).

In the present disclosure, the control voltage Vc(k) may also be simply referred to as the control voltage Vc, for simplicity.

The M-tap resistor network circuit 12 is provided with resistors R21 to R28 and the plurality of M taps. Fig. 2 shows a case where M = 6. The resistors R21 and R25 to R28 are first voltage-divider resistors connected in series between the terminal of the positive power supply voltage Vcc and the terminal of the negative power supply voltage Vee, the first voltage-divider resistors generating the reference voltages Vr2, Vr4, and Vr6 from the power supply voltage. The reference voltages Vr2, Vr4, and Vr6 occur at M/2 taps among the resistors R25 to R28. The resistors R21 to R24 and R28 are second voltage-divider resistors connected in series between the terminal of the positive power supply voltage Vcc and the terminal of the negative power supply voltage Vee, the second voltage-divider resistors generating the reference voltages Vr1, Vr3, and Vr5 from the power supply voltage. The reference voltages Vr1, Vr3, and Vr5 occur at M/2 taps among the resistors R21 to R24. Resistances of the resistors R24 and R25 are set equal to each other. In addition, the resistances of the resistors R22, R23, R26, and R27 are set equal to each other, and twice the resistance of the resistor R24 or R25. By setting the resistances of the resistors R22 to R27 in such a manner, it is possible to generate the reference voltages Vr1 to Vr6 for simultaneously generating a sine wave and a cosine wave.

In the present disclosure, the reference voltages Vr1 to Vr6 may also be simply referred to as a reference voltage Vr, for simplicity.

The resistors R10, R11, and R12 of the N-tap resistor network circuit 11, and the resistors R21 to R28 of the M-tap resistor network circuit 12 may have the same temperature coefficient with each other.

The folding circuit 13 is provided with differential amplifiers 31 to 33, and resistors R31 and R32. The differential amplifier 31 compares the control voltage Vc with the reference voltage Vr2 to generate a first differential output signal. The differential amplifier 32 compares the control voltage Vc with the reference voltage Vr4, which is higher than the reference voltage Vr2, to generate a second differential output signal. The differential amplifier 33 compares the control voltage Vc with the reference voltage Vr6, which is higher than the reference voltage Vr4, to generate a third differential output signal. Output terminals of the differential amplifiers 31 to 33 are connected to the terminal of the power supply voltage Vcc via the resistors R31 and R32. The first output signal Vsin(k) is a sum of differential output signals of the differential amplifiers 31 and 33, and an inverted signal of a differential output signal of the differential amplifier 32.

The folding circuit 14 is provided with differential amplifiers 41 to 43, and resistors R41 and R42. The differential amplifier 41 compares the control voltage Vc with the reference voltage Vr1 to generate a fourth differential output signal. The differential amplifier 42 compares the control voltage Vc with the reference voltage Vr3, which is higher than the reference voltage Vr1, to generate a fifth differential output signal. The differential amplifier 43 compares the control voltage Vc with the reference voltage Vr5, which is higher than the reference voltage Vr3, to generate a sixth differential output signal. Output terminals of the differential amplifiers 41 to 43 are connected to the terminal of the power supply voltage Vcc via the resistors R41 and R42. The second output signal Vcos(k) is a sum of differential output signals of the differential amplifiers 41 and 43, and an inverted signal of a differential output signal of the differential amplifier 42.

The signal generation circuit 10 may be implemented with a plurality of discrete elements, or may be implemented with one or more integrated circuits. Furthermore, among components of the signal generation circuit 10, at least the N-tap resistor network circuit 11 and the M-tap resistor network circuit 12 may be implemented on one integrated circuit.

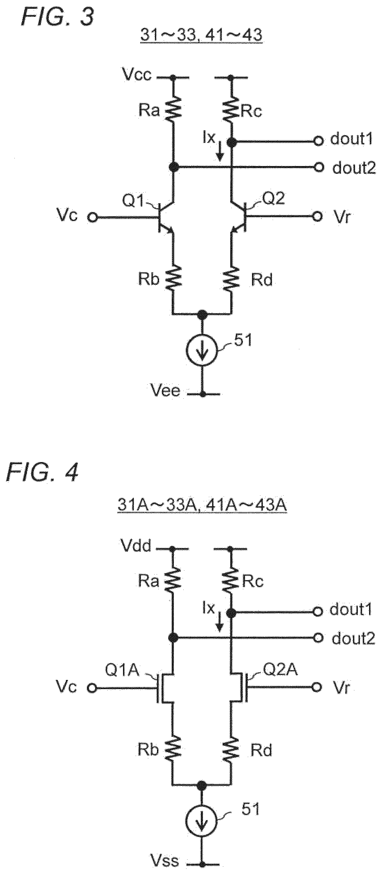

Fig. 3 is a circuit diagram showing an exemplary configuration of the differential amplifiers 31 to 33 and 41 to 43 of Fig. 2. Each of the differential amplifiers 31 to 33 and 41 to 43 is provided with a pair of bipolar transistors Q1 and Q2, a constant current source 51, and resistors Ra to Rd. The control voltage Vc is applied to a base of the bipolar transistor Q1, and the reference voltage Vr (one of the reference voltages Vr1 to Vr6) is applied to a base of the bipolar transistor Q2. An output current Ix flows through the output terminal dout1 and dout2 in accordance with a voltage difference between the control voltage Vc and the reference voltage Vr.

Fig. 4 is a circuit diagram showing another exemplary configuration of the differential amplifiers 31 to 33 and 41 to 43 of Fig. 2. The folding circuits 13 and 14 may be provided with the differential amplifiers 31A to 33A and 41A to 43A of Fig. 4, instead of the differential amplifiers 31 to 33 and 41 to 43 of Fig. 3. Each of the differential amplifiers 31A to 33A and 41A to 43A is provided with a pair of field effect transistors Q1A and Q2A, instead of the bipolar transistors Q1 and Q2 of Fig. 3.

The differential amplifiers may have emitter feedback resistors, or may include a Darlington connection. Furthermore, the folding circuits 13 and 14 may be provided with cascaded differential amplifiers, or may be provided with two-stage cascaded differential amplifiers.

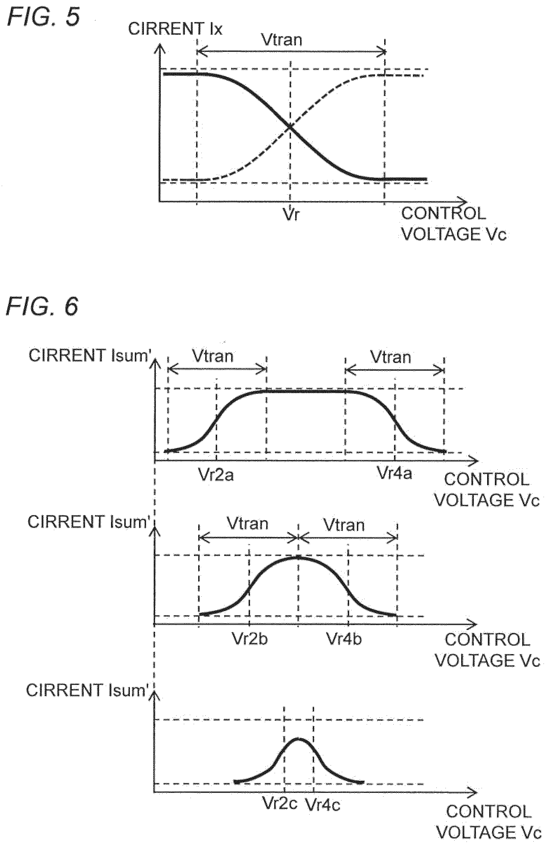

Fig. 5 is a graph schematically showing operation characteristics of each of the differential amplifiers 31 to 33 and 41 to 43 of Fig. 2. The output current Ix of each of the differential amplifiers 31 to 33 and 41 to 43 approximately varies with transmission characteristics of a hyperbolic sine function tanh(Vc) with respect to the control voltage Vc (solid line), or transmission characteristics of an inverted signal thereof (broken line). When the control voltage Vc is in a predetermined voltage range Vtran centered on the reference voltage Vr, the output current Ix varies in accordance with the control voltage Vc. On the other hand, when the control voltage Vc is outside the voltage range Vtran, the output current Ix does not substantially change even when the control voltage Vc changes.

Fig. 6 is a graph schematically showing changes in operation characteristics in cases where different reference voltages Vr2 and Vr4 are set for a pair of the differential amplifiers 31 and 32 of Fig. 2. The top, the middle, and the bottom of Fig. 6 show the current Isum', that is a sum of the output currents of the differential amplifiers 31 and 32, with respect to the change in the control voltage Vc. The top of Fig. 6 shows a case where the reference voltages Vr2 and Vr4 having a large difference (shown as reference voltages Vr2a and Vr4a) are set. The bottom of Fig. 6 shows a case where the reference voltages Vr2 and Vr4 having a small difference (shown as reference voltages Vr2c and Vr4c) are set. The middle of Fig. 6 shows a case where the reference voltages Vr2 and Vr4 having an intermediate difference (shown as reference voltages Vr2b and Vr4b) are set. By combining the differential amplifiers 31 and 32 each having characteristics of a hyperbolic sine function, the current Isum' varies with characteristics in which the two hyperbolic sine functions are connected, with respect to the control voltage Vc. In the cases of the top and the bottom of Fig. 6, the current Isum' significantly deviates from a sine wave waveform. On the other hand, in the case of the middle of Fig. 6, it can be seen that the current Isum' can be well approximated to a sine wave waveform by appropriately setting a difference between the reference voltages Vr2 and Vr4.

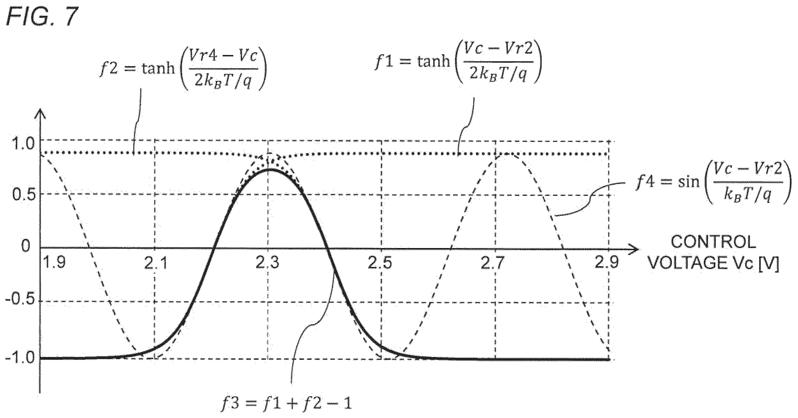

Fig. 7 is a graph explaining that the pair of differential amplifiers 31 and 32 of Fig. 2 can generate a signal having a waveform similar to a sine wave. The equation f1 represents transmission characteristics of the differential amplifier 31, and the equation f2 represents transmission characteristics of the differential amplifier 32. The equation f3 represents combined transmission characteristics of the differential amplifiers 31 and 32 adjacent to each other. The equation f4 represents an ideal sine wave. "$k_B$" represents a Boltzmann constant, "T" represents a temperature, and "q" represents an elementary charge. According to the plots of the equations f1 to f4, it is understood that the combined transmission characteristics of the differential amplifiers 31 and 32 can be well approximated to a sine wave waveform in a range of the control voltage Vc = 2.1 to 2.5.

Similarly, by appropriately setting a difference between the reference voltages Vr4 and Vr6, a sum of the output currents of the differential amplifiers 32 and 33 can also be well approximated to a sine wave waveform. In addition, by appropriately setting a difference between the reference voltages Vr1 and Vr3, a sum of the output currents of the differential amplifiers 41 and 42 can also be well approximated to a sine wave waveform. In addition, by appropriately setting a difference between the reference voltages Vr3 and Vr5, a sum of the output currents of the differential amplifiers 42 and 43 can also be well approximated to a sine wave waveform.

Each of the folding circuits 13 and 14 is an analog circuit in which an output voltage repeats increase and decrease a plurality of times in accordance with an increase or decrease of the input voltage.

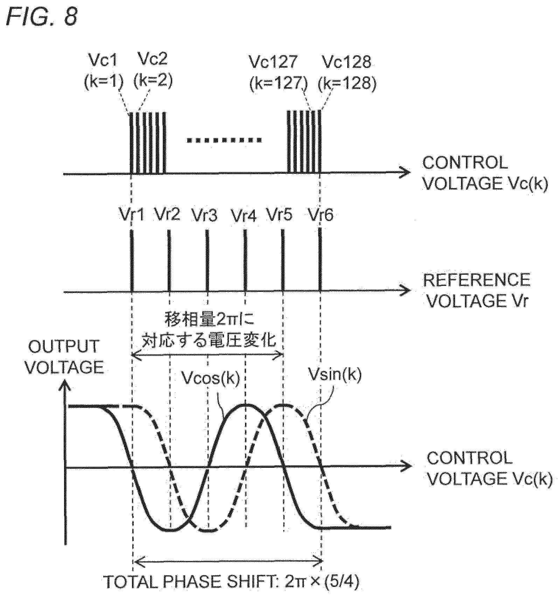

Fig. 8 is a diagram explaining a relationship among the control voltage Vc(k), the reference voltages Vr, and the output signals Vsin(k) and Vcos(k) of Fig. 1. The top of Fig. 8 shows possible voltage values Vc1, ... , Vc128 of the control voltage Vc. The middle of Fig. 8 shows possible voltage values Vr1 to Vr6 of the reference voltage Vr. The bottom of Fig. 8 shows that magnitudes of the output signals Vsin(k) and Vcos(k) vary in accordance with the control voltage Vc(k).

A total phase shift of the phase shifter 1 is $((M - 1)/4) \cdot 2\pi$ radians. For example, when the control voltage Vc varies across a voltage difference of Vr5 - Vr1 (alternatively, across a voltage difference of Vr6 - Vr2), the quadrature modulation circuit 20 produces a phase shift of $2\pi$.

An upper limit and a lower limit of the control voltage Vc(k) may be set identical to an upper limit and a lower limit of the reference voltage Vr, respectively (Vc1 = Vr1 and Vc128 = Vr6). In this case, when selecting the k-th voltage value of the N-tap resistor network circuit 11, the phase shift of the phase shifter 1 is expressed as follows.

[Mathematical Expression 4]

$$\frac{k}{N} \cdot \frac{M-1}{4} 2\pi = k\frac{M-1}{2N}\pi$$

As described above, the parameter M determines the total phase shift of the phase shifter 1. When a wide phase shift is required, a large M is set when designing the phase shifter 1. In addition, the parameter N determines a resolution with which the digital control signal k can be set. When fine resolution is required, a large N is set when designing the phase shifter 1.

[ADVANTAGEOUS EFFECTS OF FIRST EMBODIMENT]

As described above, the signal generation circuit 10 is provided with: the two folding circuits 13 and 14; and the N-tap resistor network circuit 11 and the M-tap resistor network circuit 12 that respectively generate the control voltage Vc and the reference voltage Vr used in the folding circuits 13 and 14. The folding circuits 13 and 14 generate the output signals Vsin(k) and Vcos(k) having signal levels corresponding to predetermined phases of the sine wave and cosine wave, the phases varying in proportion to the value of the digital control signal k. The output signals Vsin(k) and Vcos(k) are applied as DC coefficients to the two multipliers 22 and 23 of the quadrature modulation circuit 20. As a result, a phase of the original frequency signal to be inputted to the quadrature modulation circuit 20 is shifted by a phase proportional to the digital control signal k, and outputted as the phase-shifted frequency signal. According to the present embodiment, it is possible to provide the signal generation circuit 10 and the phase shifter 1 having a smaller circuit size and a smaller power consumption than the prior art, having tolerance to PVT variations, being digitally controllable, and having linear control characteristics with respect to a control signal.

The phase shifter 1 provided with the signal generation circuit 10 according to the embodiment has the following advantages, as compared with the case of referring to data stored in a storage device in advance as in Patent Document 1 (for example, the case of using a lookup table).

- It is possible to implement a control circuit with a much smaller number of components than the prior art, and design the circuit easily and at low cost. In addition, it is possible to reduce a chip size, and achieve a low-cost phase shifter.
- In a case where the phase shifter 1 is disposed in a front-end circuit of a wireless terminal apparatus, both the signal generation circuit 10 and the quadrature modulation circuit 20 are manufactured as a high-frequency integrated circuit, and therefore, it is possible to implement highly-matched analog circuits with a small number of components. It should be noted that there is a technical difficulty in implementing a digital circuit on a high-frequency integrated circuit.
- In a case of implementing massive multiple-input and multiple-output (massive MIMO), it is necessary to increase the number of antenna elements of an array antenna apparatus. However, in the case of using a high-frequency band, such as a millimeter wave, the number of antenna elements of the array antenna apparatus can not be increased from a viewpoint of power consumption, and therefore, it is considered to use a method of transmitting and receiving while changing beam patterns at short time intervals (time division multiple access massive MIMO or virtual massive MIMO). In the case of using such a method, it is necessary to control the phase shifter at high speed, and it is necessary to operate the signal generation circuit at high speed. Therefore, implementing the signal generation circuit 10 with analog circuits having a small number of components is particularly useful in terms of power consumption.

Since the N-tap resistor network circuit 11 and the M-tap resistor network circuit 12 can be implemented by a plurality of resistors having the same resistance with each other, or by a plurality of resistors having a certain resistance or a resistance twice thereof, integrating them can reduce variations in manufacturing process. In addition, in a case where the N-tap resistor network circuit 11 and the M-tap resistor network circuit 12 are implemented as the same type of resistors (for example, resistors having the same temperature coefficient with each other), the control voltage Vc and the reference voltage Vr are shifted in the same direction and by the same level in accordance with variations in the power supply voltage and the temperature. Since the control voltage Vc and the reference voltage Vr are inputted to the differential amplifiers 31 to 33 and 41 to 43, the voltage shifts in the same direction can be canceled due to a high common mode rejection ratio (CMRR) of the differential amplifiers.

By implementing the N-tap resistor network circuit 11 and the M-tap resistor network circuit 12 using resistors having the same temperature coefficient with each other, it is possible to achieve high tolerance to variations in temperature. Furthermore, by implementing the N-tap resistor network circuit 11 and the M-tap resistor network circuit 12 on one integrated circuit, it is possible to achieve high tolerance to variations in a manufacturing process.

As described above, the present circuit has high tolerance to variations in a manufacturing process (P), a power supply voltage (V), and a temperature (T). Having tolerance to PVT variations, it is possible to maintain the same performance in various environments.

In a case of using an analog control voltage inputted externally, instead of using the N-tap resistor network circuit 11 to generate the control voltage Vc as in the present embodiment, there is an issue of low tolerance to PVT variations, since the control voltage is generated by a mechanism different from the M-tap resistor network circuit 12 within the phase shifter. On the other hand, according to the present embodiment, the control voltage Vc and the reference voltage Vr are generated using the N-tap resistor network circuit 11 and the M-tap resistor network circuit 12, that is, the same type of resistor network circuits, thus providing high tolerance to PVT variations. Furthermore, according to the present embodiment, for example, by using the N-tap resistor network circuit 11 and the M-tap resistor network circuit 12 that are integrated with each other, it is possible to further improve the tolerance to PVT variations.

The N-tap resistor network circuit 11 and the M-tap resistor network circuit 12 can also be regarded as digital-analog converters or potentiometers. In addition, the N-tap resistor network circuit 11 and the M-tap resistor network circuit 12 provide any phase shift by arbitrarily designing and setting a voltage step width, and therefore, they are also collectively referred to as "vernier resistor network".

In a conventional phase shifter, in general, when changing the phase, the amplitude may also change. In order to reduce such a change in amplitude, it is necessary to digitally correct the amplitude using a variable gain amplifier provided in front of or subsequent to the phase shifter. However, digital correction produces a delay. In addition, since a digital correction circuit and/or a ROM for storing digital correction values are provided, a circuit size increases, and as a result, power consumption increases. On the other hand, the signal generation circuit 10 according to the embodiment has linear control characteristics with respect to the control signal, and therefore, the amplitude of the output signal is constant, independent of the phase, and no digital correction is required. Therefore, the signal generation circuit 10 according to the embodiment can operate at high speed, without a delay due to digital correction, and can operate with a smaller circuit size and a smaller power consumption than in the case of performing digital correction.

A conventional phase shifter that performs digital correction is typically implemented with a circuit including thousands of transistors, has a power consumption of a little over 10 mW to several tens mW, and has a transmission loss of less than 3dB in a temperature range of -40°C to 85°C. On the other hand, the signal generation circuit 10 according to the embodiment is implemented with, for example, a circuit including about 30 transistors, has a power consumption of about 3 mW, and has a transmission loss of less than 1dB in a temperature range of -40°C to 85°C. Therefore, the signal generation circuit 10 according to the embodiment has a smaller circuit size and a smaller power consumption than the prior art, and has higher tolerance to temperature variation than the prior art.

[VARIATIONS OF FIRST EMBODIMENT]

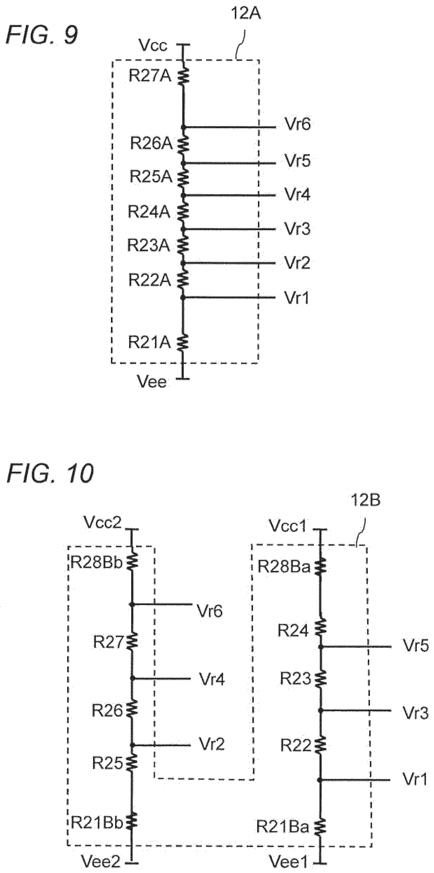

Fig. 9 is a circuit diagram showing a configuration of an M-tap resistor network circuit 12A of a signal generation circuit according to a first variation of the first embodiment. The M-tap resistor network circuit 12A is provided with resistors R21A to R27A. The resistors R21A to R27A are voltage-divider resistors connected in series between the terminal of the positive power supply voltage Vcc and the terminal of the negative power supply voltage Vee. The reference voltages Vr1 to Vr6 occur at the M taps among the resistors R21A to R27A. According to the M-tap resistor network circuit 12A of Fig. 9, it is possible to use the resistors R22A to R26A having the same resistance with each other, and therefore, reduce relative manufacturing errors, and easily manufacture the circuit.

Fig. 10 is a circuit diagram showing a configuration of an M-tap resistor network circuit 12B of a signal generation circuit according to a second variation of the first embodiment. The resistors R21Ba, R22 to R24, and R28Ba are voltage-divider resistors connected in series between a terminal of a positive power supply voltage Vcc1 and a terminal of a negative power supply voltage Vee1, the voltage-divider resistors generating the reference voltages Vr1, Vr3, and Vr5 from the power supply voltage. The resistors R21Bb, R25 to R27, and R28Bb are voltage-divider resistors connected in series between a terminal of a positive power supply voltage Vcc2 and a terminal of a negative power supply voltage Vee2, the voltage-divider resistors generating the reference voltages Vr2, Vr4, and Vr6 from the power supply voltage. The power supply voltages Vcc1 and Vcc2 are set equal to each other, and the power supply voltages Vee1 and Vee2 are set equal to each other. By improving isolation between the voltage-divider resistors R21Ba, R22 to R24, and R28Ba, and the voltage-divider resistors R21Bb, R25 to R27, and R28Bb, it is possible to reduce disturbance caused by signals from input terminals of the folding circuits 13 and 14. The circuit of Fig. 10 is advantageous in a case where input impedances of the folding circuits 13 and 14 are not sufficiently high.

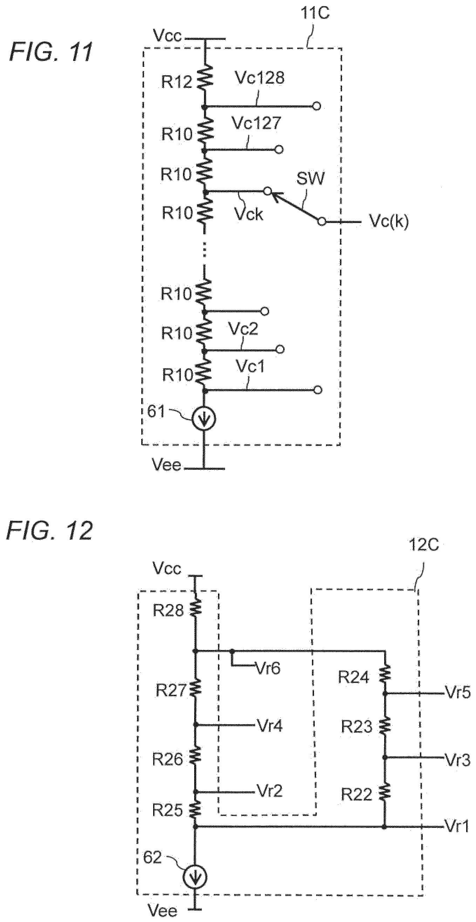

Fig. 11 is a circuit diagram showing a configuration of an N-tap resistor network circuit 11C of a signal generation circuit according to a third variation of the first embodiment. Fig. 12 is a circuit diagram showing a configuration of an M-tap resistor network circuit 12C of the signal generation circuit according to the third variation of the first embodiment. The N-tap resistor network circuit 11C is provided with a constant current source 61, instead of the resistor R11 of Fig. 2. The M-tap resistor network circuit 12C is provided with a constant current source 62, instead of the resistor R21 of Fig. 2. When the N-tap resistor network circuit 11C and the M-tap resistor network circuit 12C are integrated in one chip, the constant current sources 61 and 62 can be made with small variations in manufacturing process. Therefore, the configuration of Figs. 11 and 12 is suitable for integration.

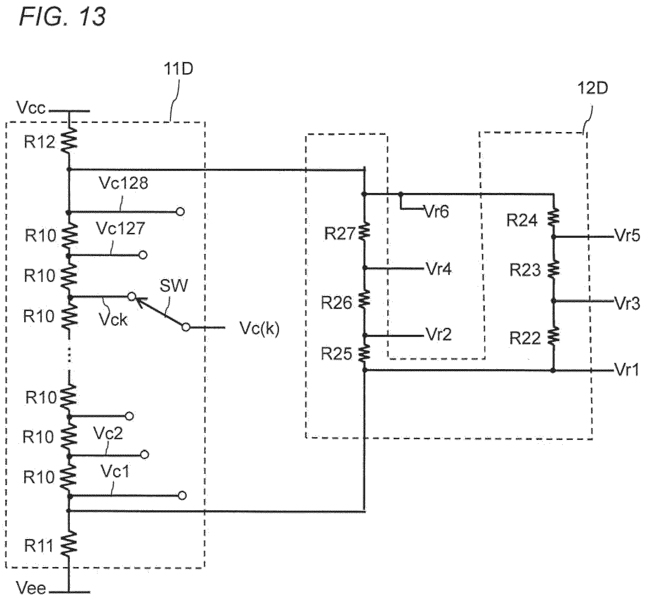

Fig. 13 is a circuit diagram showing a configuration of an N-tap resistor network circuit 11D and an M-tap resistor network circuit 12D of a signal generation circuit according to a fourth variation of the first embodiment. The M-tap resistor network circuit 12D is configured without the resistors R21 and R28 of Fig. 2, and further connected to the terminal of the positive power supply voltage Vcc and the terminal of the negative power supply voltage Vee via the resistors R11 and R12 of the N-tap resistor network circuit 11D. In other words, the N-tap resistor network circuit 11D and the M-tap resistor network circuit 12D are connected to a common voltage source. As a result, there is an advantageous effect of preventing a power supply voltage of the N-tap resistor network circuit 11D and a power supply voltage of the M-tap resistor network circuit 12D from deviating from each other.

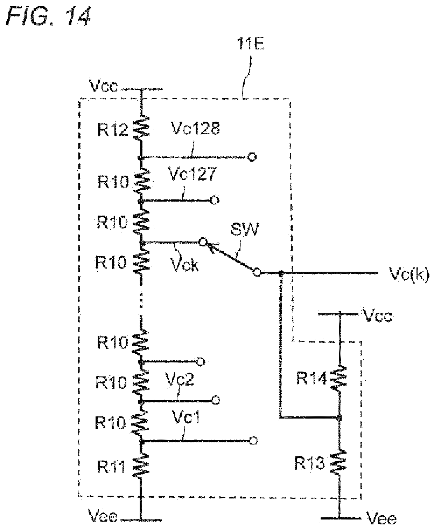

Fig. 14 is a circuit diagram showing a configuration of an N-tap resistor network circuit 11E of a signal generation circuit according to a fifth variation of the first embodiment. The N-tap resistor network circuit 11E is provided with resistors R13 and R14, in addition to the components of the N-tap resistor network circuit 11 of Fig. 2. The resistors R13 and R14 are connected in series to the terminal of the positive power supply voltage Vcc and the terminal of the negative power supply voltage Vee, and a node between the resistors R13 and R14 is connected to an output terminal of the N-tap resistor network circuit 11E. Since the N-tap resistor network circuit 11E is provided with the voltage-divider resistors R13 and R14, an impedance of the entire circuit can be reduced, thus enabling a high-speed operation.

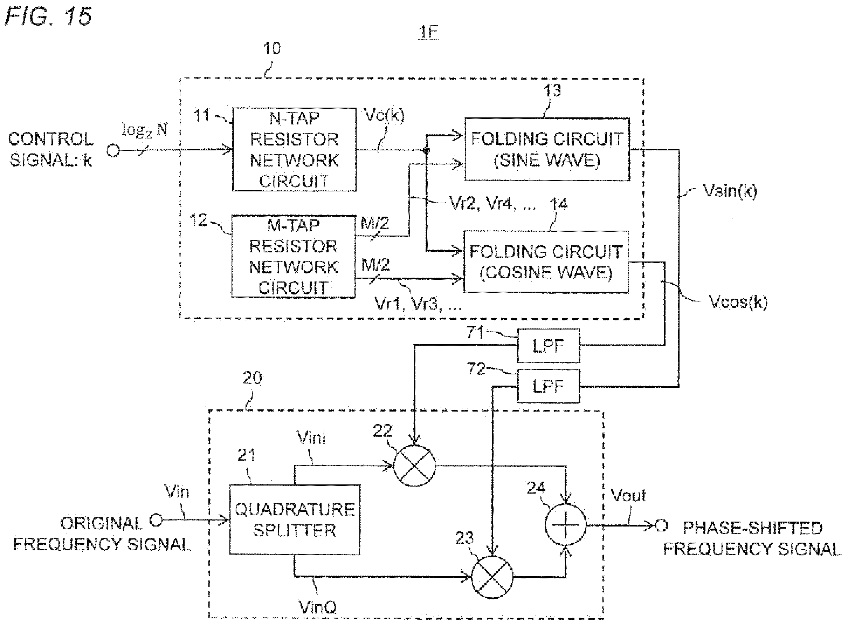

Fig. 15 is a block diagram showing a configuration of a phase shifter 1F according to a sixth variation of the first embodiment. The phase shifter 1F is provided with, in addition to the components of the phase shifter 1 of Fig. 1, low-pass filters (LPF) 71 and 72 inserted between the signal generation circuit 10 and the quadrature modulation circuit 20. The low-pass filters 71 and 72 reduce signal components of the output signals Vsin(k) and Vcos(k) of the signal generation circuit 10, the signal components having frequencies higher than a predetermined frequency. There is an issue in which, when controlling phase shifters at high speed in a phased array antenna apparatus using the phase shifters, spurious frequencies (unnecessary waves) occur in an output signal of the phased array antenna apparatus. By inserting the low-pass filters 71 and 72 between the signal generation circuit 10 and the quadrature modulation circuit 20, it is possible to smoothly change a phase of the phase shifter 1F, thus preventing spurious frequencies.

[SECOND EMBODIMENT]

In a second embodiment, we will describe a signal generation circuit and a phase shifter operable at a higher speed than that of the first embodiment.

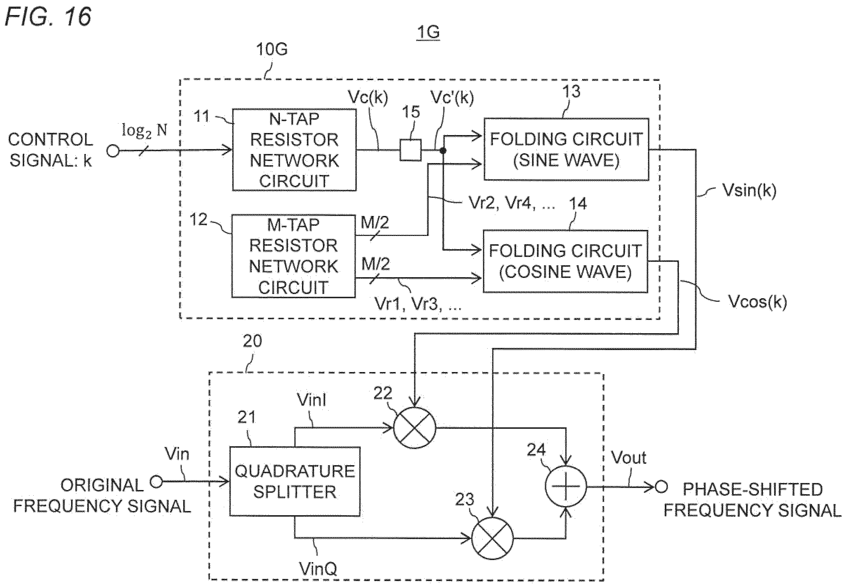

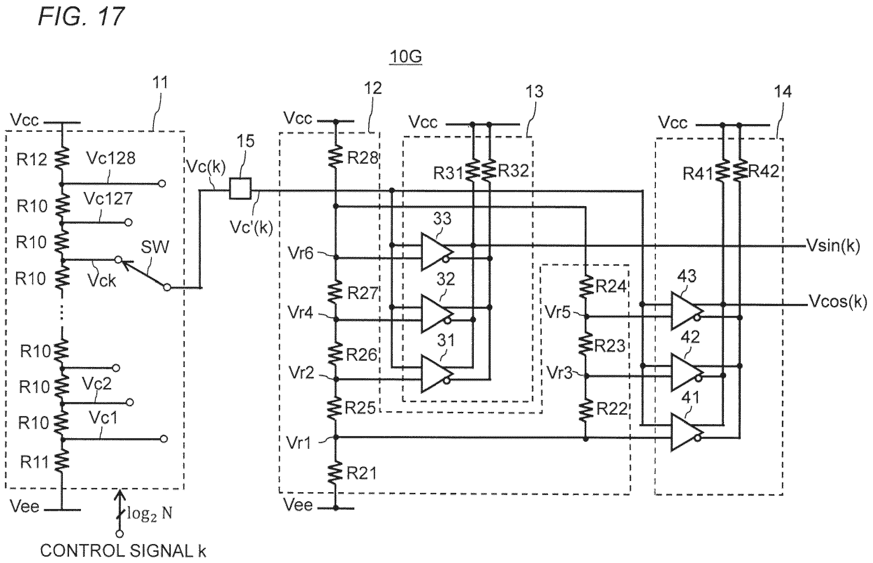

Fig. 16 is a block diagram showing a configuration of a phase shifter 1G provided with a signal generation circuit 10G according to the second embodiment. Fig. 17 is a circuit diagram showing a configuration of the signal generation circuit 10G of Fig. 16. The phase shifter 1G is provided with the signal generation circuit 10G, instead of the signal generation circuit 10 of Fig. 1. The signal generation circuit 10G is provided with, in addition to the components of the signal generation circuit 10 of Fig. 1, an impedance conversion circuit 15 provided between the N-tap resistor network circuit 11 and the folding circuits 13 and 14. The impedance conversion circuit 15 has an input impedance higher than an impedance seen from the N-tap resistor network circuit 11 to the folding circuits 13 and 14, and has an output impedance lower than an impedance seen from the folding circuits 13 and 14 to the N-tap resistor network circuit 11.

Here, the "impedance seen from the N-tap resistor network circuit 11 to the folding circuits 13 and 14" indicates an impedance seen from the N-tap resistor network circuit 11 to the folding circuits 13 and 14, when the N-tap resistor network circuit 11 and the folding circuits 13 and 14 are directly connected to each other without the impedance conversion circuit 15. The "impedance seen from the folding circuits 13 and 14 to the N-tap resistor network circuit 11" indicates an impedance seen from the folding circuits 13 and 14 to the N-tap resistor network circuit 11, iswhen the N-tap resistor network circuit 11 and the folding circuits 13 and 14 are directly connected to each other without the impedance conversion circuit 15.

The impedance conversion circuit 15 outputs a control voltage Vc'(k) that is the same as or proportional to the control voltage Vc(k) inputted from the N-tap resistor network circuit 11.

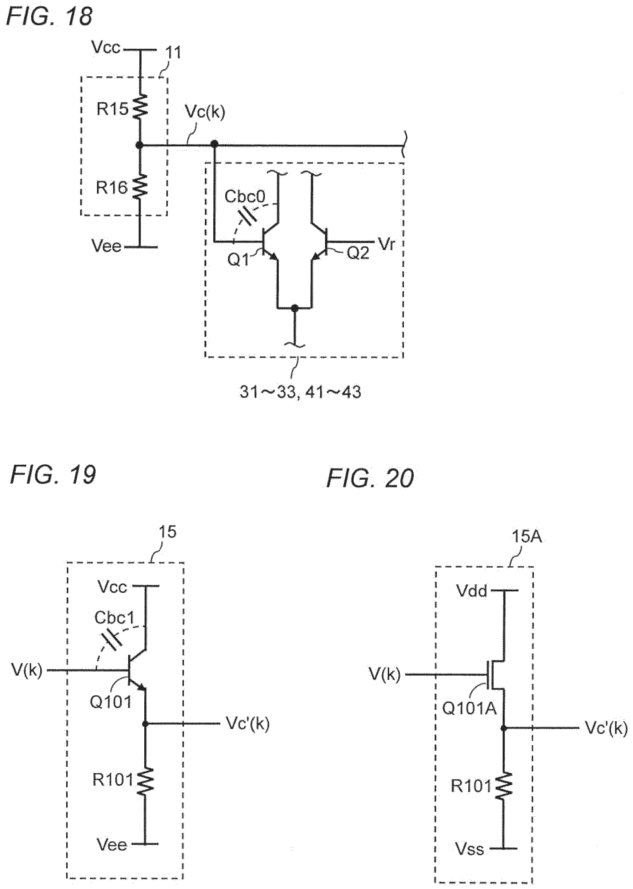

Fig. 18 is a diagram for explaining a delay occurring in the signal generation circuit 10 according to the first embodiment. Fig. 18 shows an equivalent circuit of the N-tap resistor network circuit 11, when the switch SW is connected to a selected one of the plurality of N taps. Reference sign R15 denotes a combined resistance from the selected tap to the terminal of the positive power supply voltage Vcc, and reference sign R16 denotes a combined resistance from the selected tap to the terminal of the negative power supply voltage Vee. Furthermore, the differential amplifiers 31 to 33 and 41 to 43 are configured, for example, in a manner similar to that of Fig. 3. Fig. 18 shows only the bipolar transistors Q1 and Q2 among the components of the differential amplifiers 31 to 33 and 41 to 43 of Fig. 3, for ease of illustration.

When each of the differential amplifiers 31 to 33 and 41 to 43 is provided with the bipolar transistors Q1 and Q2, each transistor has a parasitic capacitance $Cbc0$ between a base and a collector (for example, several tens fF). In the example of Fig. 2, the folding circuits 13 and 14 have a total of six differential amplifiers 31 to 33 and 41 to 41. Furthermore, one of the two input terminals (that is, the base of the bipolar transistor Q1) of each of the differential amplifiers 31 to 33 and 41 to 43 are connected in parallel to one of the two input terminals of another differential amplifier(s). Therefore, when the folding circuits 13 and 14 are seen from the N-tap resistor network circuit 11, it appears that a parasitic capacitance $6 \times Cbc0$ is connected to the N-tap resistor network circuit 11.

The resistors R15 and R16 of the N-tap resistor network circuit 11, and the parasitic capacitance $6 \times Cbc0$ of the folding circuits 13 and 14 constitute an RC circuit having a time constant 10, that is, an integration circuit. The larger the resistance $R15 \times R16/(R15+R16)$ seen from the folding circuits 13 and 14 to the N-tap resistor network circuit 11 is, the larger the time constant t0 is. Furthermore, the larger the parasitic capacitance of the folding circuits 13 and 14 is, the larger the time constant t0 is. In general, when an input voltage Vin is applied to a circuit having a resistance R and a capacitance C, an output voltage Vout of the circuit varies according to $Vout = Vin \cdot (1 - exp(-t/RC))$, and the circuit has a time constant RC (seconds). In the signal generation circuit 10 according to the first embodiment, when the digital control signal k is changed in order to change the phase, the control voltage Vc(k) cannot be instantaneously changed to a desired value, but asymptotically varies to the desired value with a slope in accordance with the time constant t0 of the circuit. The larger the time constant t0 of the circuit is, the longer a duration from when the digital control signal k is changed until the control voltage Vc(k) reaches a desired value is.

In the case where the N-tap resistor network circuit 11 and the folding circuits 13 and 14 are directly connected to each other as in the first embodiment, the time constant t0 of the circuit may be large for the following reasons, and as a result, the signal generation circuit 10 may not be operable at a sufficiently high speed.

- The parasitic capacitance seen from the N-tap resistor network circuit 11 to the folding circuits 13 and 14 is relatively large (for example, $6 \times$(several tens fF)).
- The impedance seen from the folding circuits 13 and 14 to the N-tap resistor network circuit 11 is relatively high (for example, several k$\Omega$).

Since the signal generation circuit 10G of Fig. 16 is provided with the impedance conversion circuit 15, it has the following characterizing features.

Since the N-tap resistor network circuit 11 and the folding circuits 13 and 14 are not directly connected to each other, the resistors R15 and R16 of the N-tap resistor network circuit 11, and the parasitic capacitance $6 \times Cbc0$ of the folding circuits 13 and 14 do not constitute an RC circuit.

Since the impedance conversion circuit 15 has a high input impedance, the N-tap resistor network circuit 11 has a time constant t1 that depends on the resistors R15 and R16, and a capacitance around them (parasitic capacitance or the like). The time constant t1 is substantially not affected by the parasitic capacitance $6 \times Cbc0$ of the folding circuits 13 and 14. The capacitance around the N-tap resistor network circuit 11 is expected to be smaller than the parasitic capacitance $6 \times Cbc0$ of the folding circuits 13 and 14. Therefore, the time constant t1 of the N-tap resistor network circuit 11 is smaller than the time constant t0 in the case where the N-tap resistor network circuit 11 and the folding circuits 13 and 14 are directly connected to each other.

In addition, since the impedance conversion circuit 15 has a low output impedance, the folding circuits 13 and 14 have a time constant t2 that depends on the parasitic capacitance $6 \times Cbc0$, and a resistance around it. The time constant t2 is substantially not affected by the resistors R15 and R16 of the N-tap resistor network circuit 11. The resistance around the folding circuits 13 and 14 is expected to be smaller than the resistance of the resistors R15 and R16 of the N-tap resistor network circuit 11. Therefore, the time constant t2 of the folding circuits 13 and 14 is smaller than the time constant t0 in the case where the N-tap resistor network circuit 11 and the folding circuits 13 and 14 are directly connected to each other.

The time constant t1 of the N-tap resistor network circuit 11 and the time constant t2 of the folding circuits 13 and 14 are set to satisfy t1+t2 < t0.

Fig. 19 is a circuit diagram showing a configuration of the impedance conversion circuit 15 of Fig. 16. The impedance conversion circuit 15 may be an emitter follower circuit provided with a bipolar transistor Q101 and a resistor R101. The bipolar transistor Q101 has a parasitic capacitance Cbcl between a base and a collector. The time constant t1 of the N-tap resistor network circuit 11 depends on the resistors R15 and R16, and the parasitic capacitance Cbc1. For example, in a case of $Cbc1 \approx Cbe0$, the time constant t1 of the N-tap resistor network circuit 11 is about 1/6 the time constant t0 in the case where the N-tap resistor network circuit 11 and the folding circuits 13 and 14 are directly connected to each other. Further, the bipolar transistor Q101 has a small on-resistance. The time constant t2 of the folding circuits 13 and 14 depends on the parasitic capacitance of $6 \times Cbc0$, and a resistance of the impedance conversion circuit 15. When the on-resistance of the bipolar transistor Q101 is smaller than the resistors R15 and R16 of the N-tap resistor network circuit 11, the time constant t2 of the folding circuits 13 and 14 is smaller than the time constant t0 in the case where the N-tap resistor network circuit 11 and the folding circuits 13 and 14 are directly connected to each other.

As described above, the signal generation circuit 10G has a time constant smaller than the time constant t0 in the case where the N-tap resistor network circuit 11 and the folding circuits 13 and 14 are directly connected to each other. Therefore, a duration from when the digital control signal k is changed until the control voltage Vc(k) reaches a desired value is reduced. Thus, the signal generation circuit 10G according to the second embodiment can operate at a higher speed than the signal generation circuit 10 according to the first embodiment. In addition, in a manner similar to that of the signal generation circuit 10 according to the first embodiment, the signal generation circuit 10G according to the second embodiment can provide the signal generation circuit 10G and the phase shifter 1G having a smaller circuit size and a smaller power consumption than the prior art, having tolerance to PVT variations, being digitally controllable, and having linear control characteristics with respect to the control signal.

Fig. 20 is a circuit diagram showing a configuration of an impedance conversion circuit 15A of a signal generation circuit according to a first variation of the second embodiment. The impedance conversion circuit 15A may be a source follower circuit provided with a field effect transistor Q101A and a resistor R101, and having a high input impedance and a low output impedance.

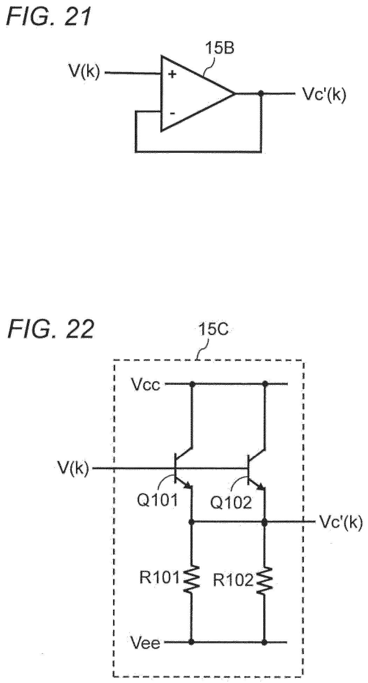

Fig. 21 is a circuit diagram showing a configuration of an impedance conversion circuit 15B of a signal generation circuit according to a second variation of the second embodiment. The impedance conversion circuit 15B may be a voltage follower circuit including an operational amplifier, and having a high input impedance and a low output impedance.

The signal generation circuit according to the second embodiment is not limited to the emitter follower circuit, the source follower circuit, or the voltage follower circuit, and it may be provided with any other impedance conversion circuit having a high input impedance and a low output impedance.

Fig. 22 is a circuit diagram showing a configuration of an impedance conversion circuit 15C of a signal generation circuit according to a third variation of the second embodiment. The impedance conversion circuit 15C is provided with a bipolar transistor Q102 and a resistor R102, in addition to the components of the impedance conversion circuit 15 of Fig. 19. The bipolar transistor Q101 and the resistor R101 constitute a "first buffer circuit", and the bipolar transistor Q102 and the resistor R102 constitute a "second buffer circuit", and these buffer circuits are connected in parallel to each other. In a case of driving the six bipolar transistors Q1 of the differential amplifiers 31 to 33 and 41 to 43, there is a possibility of not being able to supply sufficient base currents from a one-stage emitter follower circuit as shown in Fig. 19. On the other hand, by connecting the two buffer circuits in parallel to each other as shown in Fig. 22, it is possible to supply sufficient base currents to the bipolar transistors Q1 of the differential amplifiers 31 to 33 and 41 to 43.

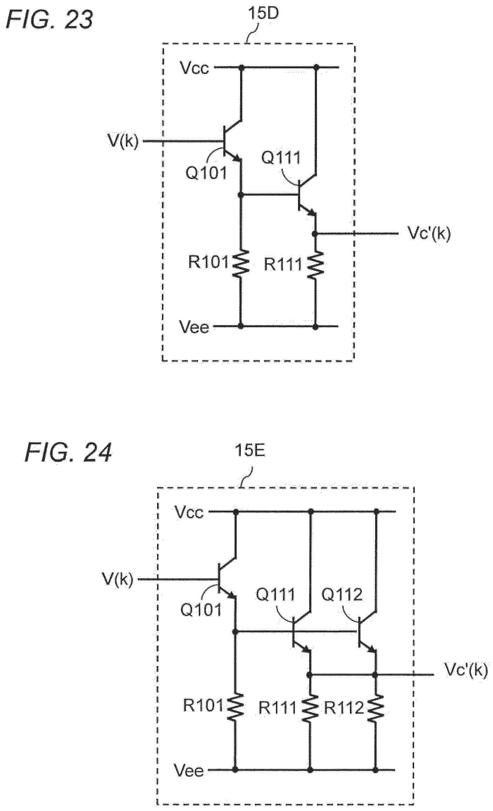

Fig. 23 is a circuit diagram showing a configuration of an impedance conversion circuit 15D of a signal generation circuit according to a fourth variation of the second embodiment. The impedance conversion circuit 15D includes a bipolar transistor Q111 and a resistor R111, in addition to the components of the impedance conversion circuit 15 of Fig. 19. The bipolar transistor Q101 and the resistor R101 constitute a "first buffer circuit", and the bipolar transistor Q111 and the resistor R111 constitute a "second buffer circuit", and these buffer circuits are cascaded to each other. When two buffer circuits are connected in parallel to each other as shown in Fig. 22, parasitic capacitance of $2 \times Cbc1$, that is twice the parasitic capacitance of Fig. 19, appear to be connected to the N-tap resistor network circuit 11. Therefore, the time constant of the N-tap resistor network circuit 11 increases as compared with the case of Fig. 19, and a duration from when the digital control signal k is changed until the control voltage Vc(k) reaches a desired value increases. On the other hand, by cascading two buffer circuits as shown in Fig. 23, it is possible to supply larger base currents than those of Fig. 19 to the bipolar transistors Q1 of the differential amplifiers 31 to 33 and 41 to 43, without increasing the time constant of the N-tap resistor network circuit 11.

Fig. 24 is a circuit diagram showing a configuration of an impedance conversion circuit 15E of a signal generation circuit according to a fifth variation of the second embodiment. The impedance conversion circuit 15E is provided with a bipolar transistor Q112 and a resistor R112, in addition to the components of the impedance conversion circuit 15D of Fig. 23. The bipolar transistor Q112 and the resistor R112 constitute a "third buffer circuit", and the third buffer circuit is connected in parallel to the second buffer circuit (that is, the bipolar transistor Q111 and the resistor R111). In the example of Fig. 23, only the second emitter follower circuit drives the six bipolar transistors Q1 of the differential amplifiers 31 to 33 and 41 to 43, and in this case, there is a possibility of not being able to supply sufficient base currents. On the other hand, by connecting the second and third buffer circuits in parallel to each other as shown in Fig. 24, it is possible to supply sufficient base currents to the bipolar transistors Q1 of the differential amplifiers 31 to 33 and 41 to 43, without increasing the time constant of the N-tap resistor network circuit 11.

While the examples of Figs. 22 to 24 illustrate the cases where the impedance conversion circuit includes a plurality of emitter follower circuits, the impedance conversion circuit may include a plurality of source follower circuits.

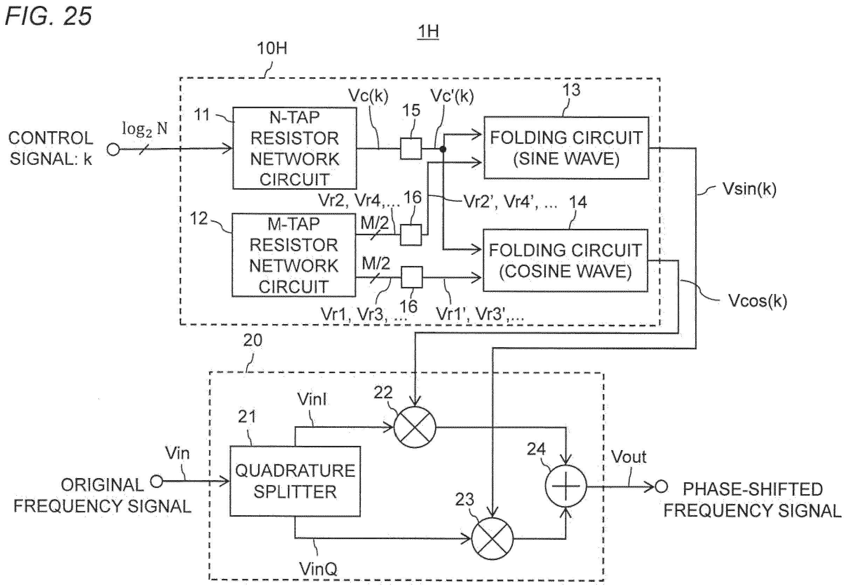

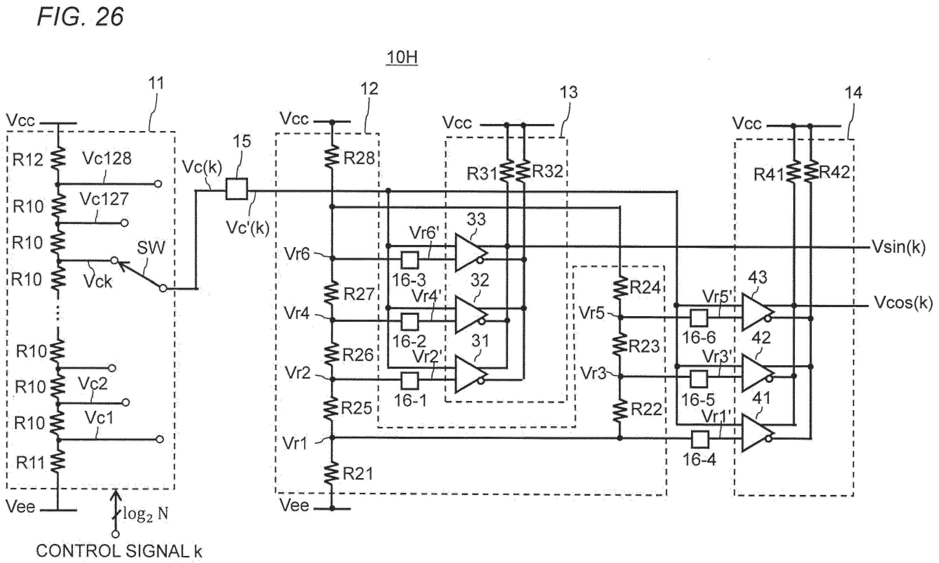

Fig. 25 is a block diagram showing a configuration of a phase shifter 1H provided with a signal generation circuit 10H according to a sixth variation of the second embodiment. Fig. 26 is a circuit diagram showing a configuration of the signal generation circuit 10H of Fig. 25. The phase shifter 1H is provided with the signal generation circuit 10H, instead of the signal generation circuit 10 of Fig. 1. The signal generation circuit 10H is provided with, in addition to the components of the signal generation circuit 10G of Figs. 16 and 17, impedance conversion circuits 16-1 to 16-6 provided between the M-tap resistor network circuit 12 and the folding circuits 13 and 14. In detail, as shown in Fig. 26, the impedance conversion circuits 16-1 to 16-6 are provided between the taps for the reference voltages Vr2, Vr4, Vr6, Vr1, Vr3, and Vr5, and the corresponding differential amplifiers 31 to 33 and 41 to 43, respectively. In Fig. 25, for ease of illustration, the impedance conversion circuits 16-1 to 16-6 are denoted by a common reference sign "16". The impedance conversion circuits 16-1 to 16-6 have the same characteristics as the characteristics of the impedance conversion circuit 15, with respect to variations in at least one of a manufacturing process, a power supply voltage, and a temperature.

The impedance conversion circuits 16-1 to 16-6 output reference voltages Vr1' to Vr6' that are the same as or proportional to the reference voltages Vr1 to Vr6 inputted from the M-tap resistor network circuit 12, respectively.

An undesirable voltage shift may occur in the control voltage Vc'(k) due to variations in a manufacturing process, a power supply voltage, or a temperature associated with the impedance conversion circuit 15. On the other hand, by providing the impedance conversion circuits 16-1 to 16-6 having the same characteristics as the characteristics of the impedance conversion circuit 15, the control voltage Vc'(k) and the reference voltages Vr1' to Vr6' shift in the same direction in accordance with the variations in the power supply voltage and the temperature. Since the control voltage Vc'(k) and the reference voltages Vr1' to Vr6' are inputted to the differential amplifiers 31 to 33 and 41 to 43, the voltage shifts in the same direction can be canceled due to a high common mode rejection ratio (CMRR) of the differential amplifiers. Even when absolute errors occur in the voltages generated by the respective impedance conversion circuits 15 and 16-1 to 16-6, it is possible to reduce the voltage shifts as long as the relative errors among the impedance conversion circuits 15 and 16-1 to 16-6 are small. As described above, since the impedance conversion circuit 15H is provided with the impedance conversion circuits 16-1 to 16-6, it has high tolerance to PVT variations.

In order to achieve simultaneous connections of a large number of transmitters and a large number of receivers, it is expected to apply a massive MIMO (mMIMO) system using a phased array antenna apparatus including a very large number of antenna elements. However, in the high-frequency band, there is a concern that an increase in the number of antenna elements leads to an increase in power consumption. Therefore, it is proposed to achieve a function equivalent to the mMIMO by steering a beam in a plurality of directions in a short time (for example, a time period of one symbol or less), even when using a phased array antenna apparatus including a small number of antenna elements. In order to achieve such beam steering, it is necessary to control phase shifters at high speed so as to change, at high speed, phases of signals transmitted and received by the antenna elements. Conventionally, the phase shifter capable of setting an arbitrary phase is provided with, for example, a digital processing circuit for correcting amplitude changes, or a lookup table storing amplitude information, and an operation speed of the phase shifter is limited by an operation speed of the digital arithmetic circuit or the lookup table. According to the second embodiment, it is possible to control the phase shifters at high speed so as to change, at high speed, phases of signals transmitted and received by the antenna elements, without need for a digital arithmetic circuit, a lookup table, or the like.

[THIRD EMBODIMENT]

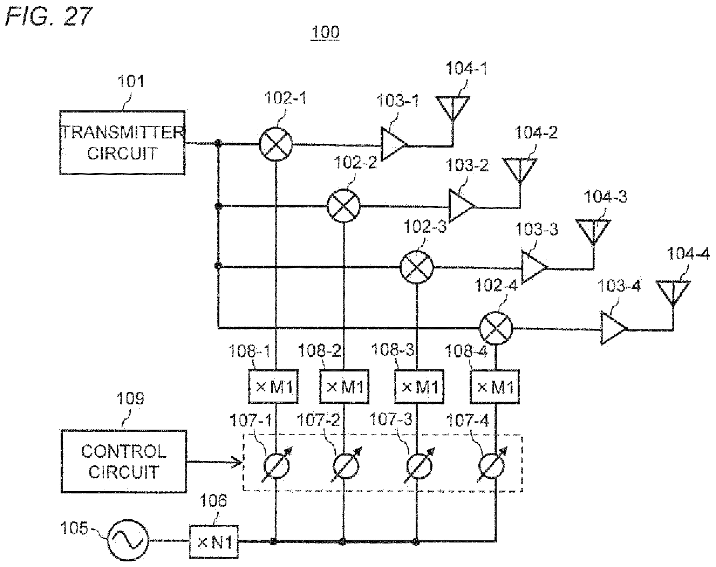

Fig. 27 is a block diagram showing a configuration of a wireless communication apparatus 100 according to a third embodiment. The wireless communication apparatus 100 is provided with a transmitter circuit 101, mixers 102-1 to 102-4, amplifiers 103-1 to 103-4, antenna elements 104-1 to 104-4, a frequency synthesizer 105, a frequency multiplier 106, phase shifters 107-1 to 107-4, frequency multipliers 108-1 to 108-4, and a control circuit 109.

The transmitter circuit 101 sends a baseband signal to the mixers 102-1 to 102-4, the baseband signal including data to be transmitted.

The frequency synthesizer 105 generates a high-frequency signal having a predetermined frequency. The frequency multiplier 106 multiplies a frequency of the high-frequency signal generated by the frequency synthesizer 105, and then sends the output signal to the phase shifters 107-1 to 107-4.

Each of the phase shifters 107-1 to 107-4 is configured in a manner similar to that of the phase shifter 1 according to the first embodiment, or the phase shifter 1G or 1H according to the second embodiment. The phase shifters 107-1 to 107-4 are provided with digital control signals k1 to k4 from the control circuit 109, respectively. The phase shifters 107-1 to 107-4 change the phases of the high-frequency signals inputted from the frequency multiplier 106, in accordance with the digital control signals k1 to k4, respectively. The control circuit 109 changes the phases of the high-frequency signals arbitrarily and independently, using the digital control signals k1 to k4.

The frequency multipliers 108-1 to 108-4 multiply the frequencies of the high-frequency signals outputted from the phase shifters 107-1 to 107-4, and then send the output signals to the mixers 102-1 to 102-4.

The mixers 102-1 to 102-4 modulates the high-frequency signals (radio frequency signals) inputted from the frequency multipliers 108-1 to 108-4, with the baseband signal inputted from the transmitter circuit 101. The output signals of the mixers 102-1 to 102-4 are respectively amplified by the amplifiers 103-1 to 103-4, and then, emitted through the antenna elements 104-1 to 104-4.

The antenna elements 104-1 to 104-4 operate as a phased array antenna apparatus, since the phase shifters 107-1 to 107-4 change the phases of the radio frequency signals to be transmitted. By accurately changing the phases of the radio frequency signals using the phase shifters 107-1 to 107-4, it is possible to improve the directivity of the antenna apparatus.

Although Fig. 27 shows the wireless communication apparatus 100 provided with the transmitter circuit 101, the phase shifter 1 according to the first embodiment, and the phase shifters 1G and 1H according to the second embodiment can be similarly applied to a wireless communication apparatus provided with a receiver circuit. In a case where the wireless communication apparatus is provided with a receiver circuit, a direction of arrival may be estimated based on the received signals, or the beam may be directed in the direction of arrival using phase shifters.

According to the third embodiment, it is possible to provide a wireless communication apparatus using a high-frequency band, such as a millimeter wave and a terahertz wave.

[OTHER EMBODIMENTS]

The above-described embodiments and variations may be arbitrarily combined with each other.

In the examples of Fig. 2 and others, the reference voltages Vr1 to Vr6 for the differential amplifiers 31 to 33 and 41 to 43 are set in the order of Vr1 < Vr2 < Vr3 < Vr4 < Vr5 < Vr6. However, the reference voltages Vr1 to Vr6 may be set in other orders, for example, in the order of Vr2 < Vr1 < Vr4 < Vr3 < Vr6 < Vr5.

Although Fig. 1 and others illustrate the case where the signal generation circuit 10 generates both the sine wave and the cosine wave, the technique described herein is also applicable to a case of generating only one of the sine wave and the cosine wave. In that case, the signal generation circuit is provided with only one of the folding circuits 13 and 14. The output signal of the signal generation circuit may be provided to any circuit that uses a signal level corresponding to a predetermined phase of a sine wave or a cosine wave, for example, a direct digital synthesizer that digitally generates a sine wave signal or a cosine wave signal.

[SUMMARY OF EMBODIMENTS]

The signal generation circuit, the phase shifter, the array antenna apparatus, and the wireless communication apparatus of aspects of the present disclosure may be expressed as follows.

A signal generation circuit of a first aspect of the present disclosure is provided with: a first resistor network circuit, a second resistor network circuit, and at least one folding circuit. The first resistor network circuit is provided with a plurality of first resistors and a plurality of first taps. The first resistor network circuit generates a control voltage having one of a plurality of predetermined voltage values by selecting one of the plurality of first taps in accordance with an inputted digital control signal. The second resistor network circuit is provided with a plurality of second resistors and a plurality of second taps. The second resistor network circuit generates a plurality of predetermined reference voltages at the plurality of second taps. The at least one folding circuit generates an output signal based on differences between the control voltage and the plurality of reference voltages, the output signal having a signal level corresponding to a predetermined phase of a sine wave or a cosine wave.

According to a signal generation circuit of a second aspect of the present disclosure, the signal generation circuit of the first aspect is further configured as follows. The signal generation circuit is provided with: a first folding circuit that generates a first output signal having a signal level corresponding to a predetermined phase of a sine wave; and a second folding circuit that generates a second output signal having a signal level corresponding to a predetermined phase of a cosine wave.

According to a signal generation circuit of a third aspect of the present disclosure, the signal generation circuit of the second aspect is further configured as follows. The first folding circuit is provided with: a first differential amplifier that compares the control voltage with a first reference voltage to generate a first differential output signal; a second differential amplifier that compares the control voltage with a second reference voltage higher than the first reference voltage to generate a second differential output signal; and a third differential amplifier that compares the control voltage with a third reference voltage higher than the second reference voltage to generate a third differential output signal. The second folding circuit is provided with: a fourth differential amplifier that compares the control voltage with a fourth reference voltage to generate a fourth differential output signal; a fifth differential amplifier that compares the control voltage with a fifth reference voltage higher than the fourth reference voltage to generate a fifth differential output signal; and a sixth differential amplifier that compares the control voltage with a sixth reference voltage higher than the fifth reference voltage to generate a sixth differential output signal. The first output signal is a sum of the first and third differential output signals and an inverted signal of the second differential output signal. The second output signal is a sum of the fourth and sixth differential output signals and an inverted signal of the fifth differential output signal.

According to a signal generation circuit of a fourth aspect of the present disclosure, the signal generation circuit of the third aspect is further configured as follows. Each of the first to sixth differential amplifiers is provided with a pair of bipolar transistors or a pair of field effect transistors.

According to a signal generation circuit of a fifth aspect of the present disclosure, the signal generation circuit of one of the first to fourth aspects is further configured as follows. The first resistor network circuit is further provided with a first constant current source connected to the plurality of first resistors.

According to a signal generation circuit of a sixth aspect of the present disclosure, the signal generation circuit of one of the first to fifth aspects is further configured as follows. The first resistor network circuit is further provided with voltage-divider resistors connected to an output terminal of the first resistor network circuit.

According to a signal generation circuit of a seventh aspect of the present disclosure, the signal generation circuit of the third aspect is further configured as follows. The second resistor network circuit is provided with voltage-divider resistors that generate the first to sixth reference voltages from a power supply voltage.

According to a signal generation circuit of an eighth aspect of the present disclosure, the signal generation circuit of the third aspect is further configured as follows. The second resistor network circuit is further provided with: first voltage-divider resistors that generates the first to third reference voltages from a power supply voltage; and second voltage-divider resistors that generates the fourth to sixth reference voltages from the power supply voltage.

According to a signal generation circuit of a ninth aspect of the present disclosure, the signal generation circuit of the third aspect is further configured as follows. The second resistor network circuit is further provided with: first voltage-divider resistors that generates the first to third reference voltages from a first power supply voltage; and second voltage-divider resistors that generates the fourth to sixth reference voltages from a second power supply voltage.

According to a signal generation circuit of a tenth aspect of the present disclosure, the signal generation circuit of one of the first to ninth aspects is further configured as follows. The second resistor network circuit is further provided with a second constant current source connected to the plurality of second resistors.

According to a signal generation circuit of an eleventh aspect of the present disclosure, the signal generation circuit of the first aspect is further configured as follows. The first and second resistor network circuits are connected to a common voltage source.

According to a signal generation circuit of a twelfth aspect of the present disclosure, the signal generation circuit of one of the first to eleventh aspects is further configured as follows. The signal generation circuit is further provided with the first impedance conversion circuit between the first resistor network circuit and the at least one folding circuit. The first impedance conversion circuit has an input impedance higher than an impedance seen from the first resistor network circuit to the at least one folding circuit, and has an output impedance lower than an impedance seen from the at least one folding circuit to the first resistor network circuit.

According to a signal generation circuit of a thirteenth aspect of the present disclosure, the signal generation circuit of the twelfth aspect is further configured as follows. The first impedance conversion circuit includes an emitter follower circuit, a source follower circuit, or a voltage follower circuit.

According to a signal generation circuit of a fourteenth aspect of the present disclosure, the signal generation circuit of the twelfth or thirteenth aspect is further configured as follows. The first impedance conversion circuit includes a first buffer circuit and a second buffer circuit connected in parallel to each other.

According to a signal generation circuit of a fifteenth aspect of the present disclosure, the signal generation circuit of the twelfth or thirteenth aspect is further configured as follows. The first impedance conversion circuit includes: a first buffer circuit; and a second buffer circuit cascaded subsequent to the first buffer circuit.

According to a signal generation circuit of a sixteenth aspect of the present disclosure, the signal generation circuit of the fifteenth aspect is further configured as follows. The first impedance conversion circuit further includes a third buffer circuit connected in parallel to the second buffer circuit.

According to a signal generation circuit of a seventeenth aspect of the present disclosure, the signal generation circuit of one of the twelfth to sixteenth aspects is further configured as follows. The signal generation circuit is further provided with a second impedance conversion circuit provided between the second resistor network circuit and the at least one folding circuit. The second impedance conversion circuit has characteristics identical to characteristics of the first impedance conversion circuit, with respect to variations in at least one of a manufacturing process, a power supply voltage, and a temperature.

According to a signal generation circuit of an eighteenth aspect of the present disclosure, the signal generation circuit of one of first to seventeenth aspects is further configured as follows. The first and second resistors have a same temperature coefficient to each other.

According to a signal generation circuit of a nineteenth aspect of the present disclosure, the signal generation circuit of one of first to eighteenth aspects is further configured as follows. The first and second resistor network circuits are implemented on one integrated circuit.

A phase sifter of a 20th aspect of the present disclosure is provided with: the signal generation circuit of the second aspect, or the signal generation circuit of one of third to nineteenth aspects depending on the second aspect; a quadrature splitter that splits an input signal into an in-phase signal and a quadrature-phase signal; a first multiplier that multiplies the in-phase signal by the second output signal of the signal generation circuit to generate a first multiplication signal; a second multiplier that multiplies the quadrature-phase signal by the first output signal of the signal generation circuit to generate a second multiplication signal; and a combiner that combines the first multiplication signal and the second multiplication signal with each other.

According to a phase sifter of a 21st aspect of the present disclosure, the phase sifter of the 20th aspect is further configured as follows. The phase shifter is further provided with a low-pass filter that reduces signal components of the first and second output signals of the signal generation circuit, the signal components having frequencies higher than a predetermined frequency.

An array antenna apparatus of a 22nd aspect of the present disclosure is provided with: a plurality of antenna elements; a plurality of third mixers; and a plurality of the phase shifters of the 20th or 21st aspect.

A wireless communication apparatus of a 23rd aspect of the present disclosure is provided with: the array antenna apparatus of the 22nd aspect; and a communication circuit.

INDUSTRIAL APPLICABILITY

The signal generation circuit, the phase shifter, the array antenna apparatus, and the wireless communication apparatus according to one aspect of the present disclosure are applicable to, for example, a base station or a mobile station of a wireless communication system. The signal generation circuit, the phase shifter, the array antenna apparatus, and the wireless communication apparatus according to one aspect of the present disclosure are applicable to, for example, phase shifter units for a phased array antenna apparatus that is planned to be incorporated into satellite communication and a meteorological radar.

REFERENCE SIGNS LIST

1, 1F to 1H: phase shifter
10, 10G, 10H: signal generation circuit
11, 11C to 11E: N-tap resistor network circuit
12, 12A to 12D: M-tap resistor network circuit
13, 14: folding circuit
15, 15A to 15E, 16, 16-1 to 16-6: impedance conversion circuit
20: quadrature modulation circuit
21: quadrature splitter
22, 23: multiplier
24: combiner
31 to 33: differential amplifier
41 to 43: differential amplifier
51: constant current source
61, 62: constant current source
71, 72: low-pass filter (LPF)
100: wireless communication apparatus
101: transmitter circuit
102-1 to 102-4: mixer
103-1 to 103-4: amplifier
104-1 to 104-4: antenna element
105: frequency synthesizer
106: frequency multiplier
107-1 to 107-4: phase shifter
108-1 to 108-4: frequency multiplier
109: control circuit
R, R10 to R14, R21 to R28, R21A to R27A, R21Ba, R21Bb, R28Ba, R28Bb, R31, R32, R41, R42, R101, R102, R1111, R112, Ra to Rd: resistor
Q1, Q2, Q101, Q102, Q111, Q112: bipolar transistor
Q1A, Q2A, Q101A: field effect transistor
SW: switch

**Claims**

1. A signal generation circuit comprising:

a first resistor network circuit comprising a plurality of first resistors and a plurality of first taps, wherein the first resistor network circuit generates a control voltage having one of a plurality of predetermined voltage values by selecting one of the plurality of first taps in accordance with an inputted digital control signal;
a second resistor network circuit comprising a plurality of second resistors and a plurality of second taps, wherein the second resistor network circuit generates a plurality of predetermined reference voltages at the plurality of second taps; and
at least one folding circuit that generates an output signal based on differences between the control voltage and the plurality of reference voltages, the output signal having a signal level corresponding to a predetermined phase of a sine wave or a cosine wave.

2. The signal generation circuit according to claim 1, comprising:

a first folding circuit that generates a first output signal having a signal level corresponding to a predetermined phase of a sine wave; and
a second folding circuit that generates a second output signal having a signal level corresponding to a predetermined phase of a cosine wave.

3. The signal generation circuit according to claim 2, wherein the first folding circuit comprises:

a first differential amplifier that compares the control voltage with a first reference voltage to generate a first differential output signal;
a second differential amplifier that compares the control voltage with a second reference voltage higher than the first reference voltage to generate a second differential output signal; and
a third differential amplifier that compares the control voltage with a third reference voltage higher than the second reference voltage to generate a third differential output signal,
wherein the second folding circuit comprises:

a fourth differential amplifier that compares the control voltage with a fourth reference voltage to generate a fourth differential output signal;
a fifth differential amplifier that compares the control voltage with a fifth reference voltage higher than the fourth reference voltage to generate a fifth differential output signal; and
a sixth differential amplifier that compares the control voltage with a sixth reference voltage higher than the fifth reference voltage to generate a sixth differential output signal,
wherein the first output signal is a sum of the first and third differential output signals and an inverted signal of the second differential output signal, and
wherein the second output signal is a sum of the fourth and sixth differential output signals and an inverted signal of the fifth differential output signal.

4. The signal generation circuit according to claim 3,
wherein each of the first to sixth differential amplifiers comprises a pair of bipolar transistors or a pair of field effect transistors.

5. The signal generation circuit according to claim 1,
wherein the first resistor network circuit further comprises a first constant current source connected to the plurality of first resistors.

6. The signal generation circuit according to claim 1,
wherein the first resistor network circuit further comprises voltage-divider resistors connected to an output terminal of the first resistor network circuit.

7. The signal generation circuit according to claim 3,
wherein the second resistor network circuit comprises voltage-divider resistors that generate the first to sixth reference voltages from a power supply voltage.

8. The signal generation circuit according to claim 3,
   wherein the second resistor network circuit further comprises:

   first voltage-divider resistors that generates the first to third reference voltages from a power supply voltage; and
   second voltage-divider resistors that generates the fourth to sixth reference voltages from the power supply voltage.

9. The signal generation circuit according to claim 3,
   wherein the second resistor network circuit further comprises:

   first voltage-divider resistors that generates the first to third reference voltages from a first power supply voltage; and
   second voltage-divider resistors that generates the fourth to sixth reference voltages from a second power supply voltage.

10. The signal generation circuit according to claim 1,
    wherein the second resistor network circuit further comprises a second constant current source connected to the plurality of second resistors.

11. The signal generation circuit according to claim 1,
    wherein the first and second resistor network circuits are connected to a common voltage source.

12. The signal generation circuit according to claim 1,
    wherein the first and second resistors have a same temperature coefficient to each other.

13. The signal generation circuit according to claim 1,
    wherein the first and second resistor network circuits are implemented on one integrated circuit.

14. A phase shifter comprising:

    the signal generation circuit according to claim 2;
    a quadrature splitter that splits an input signal into an in-phase signal and a quadrature-phase signal;
    a first multiplier that multiplies the in-phase signal by the second output signal of the signal generation circuit to generate a first multiplication signal;
    a second multiplier that multiplies the quadrature-phase signal by the first output signal of the signal generation circuit to generate a second multiplication signal; and
    a combiner that combines the first multiplication signal and the second multiplication signal with each other.

15. The phase shifter according to claim 14, further comprising
    a low-pass filter that reduces signal components of the first and second output signals of the signal generation circuit, the signal components having frequencies higher than a predetermined frequency.

16. An array antenna apparatus comprising:

    a plurality of antenna elements;
    a plurality of third mixers; and
    a plurality of the phase shifters according to claim 14.

17. A wireless communication apparatus comprising:

    the array antenna apparatus according to claim 16; and
    a communication circuit.

18. A signal generation circuit comprising:

    a first resistor network circuit comprising a plurality of first resistors and a plurality of first taps, wherein the first resistor network circuit generates a control voltage having one of a plurality of predetermined voltage values by selecting one of the plurality of first taps in accordance with an inputted digital control signal;

a second resistor network circuit comprising a plurality of second resistors and a plurality of second taps, wherein the second resistor network circuit generates a plurality of predetermined reference voltages at the plurality of second taps;

at least one folding circuit that generates an output signal based on differences between the control voltage and the plurality of reference voltages, the output signal having a signal level corresponding to a predetermined phase of a sine wave or a cosine wave; and

a first impedance conversion circuit provided between the first resistor network circuit and the at least one folding circuit,

wherein the first impedance conversion circuit has an input impedance higher than an impedance seen from the first resistor network circuit to the at least one folding circuit, and has an output impedance lower than an impedance seen from the at least one folding circuit to the first resistor network circuit.

19. The signal generation circuit according to claim 18,
wherein the first impedance conversion circuit includes an emitter follower circuit, a source follower circuit, or a voltage follower circuit.

20. The signal generation circuit according to claim 18,
wherein the first impedance conversion circuit includes a first buffer circuit and a second buffer circuit connected in parallel to each other.

21. The signal generation circuit according to claim 18, wherein the first impedance conversion circuit includes:

a first buffer circuit; and
a second buffer circuit cascaded subsequent to the first buffer circuit.

22. The signal generation circuit according to claim 21,
wherein the first impedance conversion circuit further includes a third buffer circuit connected in parallel to the second buffer circuit.

23. The signal generation circuit according to claim 18, further comprising

a second impedance conversion circuit provided between the second resistor network circuit and the at least one folding circuit,
wherein the second impedance conversion circuit has characteristics identical to characteristics of the first impedance conversion circuit, with respect to variations in at least one of a manufacturing process, a power supply voltage, and a temperature.

24. The signal generation circuit according to any one of clams 18 to 23, further comprising:

a first folding circuit that generates a first output signal having a signal level corresponding to a predetermined phase of a sine wave; and
a second folding circuit that generates a second output signal having a signal level corresponding to a predetermined phase of a cosine wave.

25. The signal generation circuit according to claim 18,
wherein the first and second resistors have a same temperature coefficient to each other.

26. The signal generation circuit according to claim 18,
wherein the first and second resistor network circuits are implemented on one integrated circuit.

27. A phase shifter comprising:

the signal generation circuit according to claim 24;
a quadrature splitter that splits an input signal into an in-phase signal and a quadrature-phase signal;
a first multiplier that multiplies the in-phase signal by the second output signal of the signal generation circuit to generate a first multiplication signal;
a second multiplier that multiplies the quadrature-phase signal by the first output signal of the signal generation circuit to generate a second multiplication signal; and

a combiner that combines the first multiplication signal and the second multiplication signal with each other.

28. An array antenna apparatus comprising:

a plurality of antenna elements;
a plurality of mixers; and
a plurality of the phase shifters according to claim 27.

29. A wireless communication apparatus comprising:

the array antenna apparatus according to claim 28; and
a communication circuit.

EP 4 560 918 A1

*FIG. 1*

FIG. 2

FIG. 3

31~33, 41~43

FIG. 4

31A~33A, 41A~43A

FIG. 5

FIG. 6

FIG. 7

EP 4 560 918 A1

$$f2 = \tanh\left(\frac{Vr4 - Vc}{2k_B T/q}\right)$$

$$f1 = \tanh\left(\frac{Vc - Vr2}{2k_B T/q}\right)$$

$$f4 = \sin\left(\frac{Vc - Vr2}{k_B T/q}\right)$$

CONTROL
VOLTAGE Vc [V]

$$f3 = f1 + f2 - 1$$

FIG. 8

Vc1    Vc2                Vc127    Vc128
(k=1)  (k=2)              (k=127)  (k=128)

CONTROL
VOLTAGE Vc(k)

Vr1  Vr2  Vr3  Vr4  Vr5  Vr6

REFERENCE
VOLTAGE Vr

OUTPUT
VOLTAGE

移相量2πに
対応する電圧変化

Vcos(k)

Vsin(k)

CONTROL
VOLTAGE Vc(k)

TOTAL PHASE SHIFT: 2π × (5/4)

*FIG. 9*

*FIG. 10*

*FIG. 11*

*FIG. 12*

EP 4 560 918 A1

## FIG. 13

FIG. 14

FIG. 15

CONTROL SIGNAL: k

$\log_2 N$

1F

10

11 — N-TAP RESISTOR NETWORK CIRCUIT

Vc(k)

13 — FOLDING CIRCUIT (SINE WAVE)

Vsin(k)

12 — M-TAP RESISTOR NETWORK CIRCUIT

M/2

Vr2, Vr4, ...

14 — FOLDING CIRCUIT (COSINE WAVE)

M/2

Vr1, Vr3, ...

Vcos(k)

71 — LPF

72 — LPF

20

21 — QUADRATURE SPLITTER

Vin

ORIGINAL FREQUENCY SIGNAL

VinI

22

VinQ

23

24

Vout

PHASE-SHIFTED FREQUENCY SIGNAL

EP 4 560 918 A1

FIG. 16

FIG. 17

EP 4 560 918 A1

FIG. 18

31~33, 41~43

FIG. 19

FIG. 20

FIG. 21

FIG. 22

*FIG. 23*

15D

Vcc

V(k)

Q101

Q111

Vc'(k)

R101    R111

Vee

*FIG. 24*

15E

Vcc

V(k)

Q101

Q111    Q112

Vc'(k)

R101    R111    R112

Vee

FIG. 25

*FIG. 26*

10H

EP 4 560 918 A1

FIG. 27

## INTERNATIONAL SEARCH REPORT

International application No.

**PCT/JP2023/024674**

| A. | CLASSIFICATION OF SUBJECT MATTER |
|---|---|

*H03H 11/40*(2006.01)i; *H01Q 3/36*(2006.01)i; *H03C 3/00*(2006.01)i; *H03H 11/16*(2006.01)i; *H03H 11/20*(2006.01)i
FI: H03H11/40; H01Q3/36; H03H11/20 A; H03C3/00 A; H03H11/16 Z

According to International Patent Classification (IPC) or to both national classification and IPC

| B. | FIELDS SEARCHED |
|---|---|

Minimum documentation searched (classification system followed by classification symbols)

H03H11/40; H01Q3/36; H03C3/00; H03H11/16; H03H11/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2010/021280 A1 (NIPPON TELEGRAPH AND TELEPHONE CORPORATION) 25 February 2010 (2010-02-25) paragraphs [0022], [0068]-[0154], fig. 1, 12-40 | 1-5, 7-29 |
| A | paragraphs [0022], [0068]-[0154], fig. 1, 12-40 | 6 |
| Y | JP 2011-109162 A (SEIKO EPSON CORP) 02 June 2011 (2011-06-02) paragraphs [0075]-[0077], fig. 1, 7 | 1-5, 7-29 |
| A | paragraphs [0075]-[0077], fig. 1, 7 | 6 |
| Y | JP 2014-182346 A (SONY CORP) 29 September 2014 (2014-09-29) paragraphs [0039]-[0040], fig. 5 | 1-5, 7-29 |
| A | paragraphs [0039]-[0040], fig. 5 | 6 |
| Y | JP 11-205693 A (TOSHIBA CORP) 30 July 1999 (1999-07-30) paragraph [0021], fig. 1 | 19, 21-22, 24, 27-29 |
| Y | JP 2010-016672 A (MITSUMI ELECTRIC CO LTD) 21 January 2010 (2010-01-21) paragraphs [0028]-[0029], fig. 2 | 19, 21-22, 24, 27-29 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 August 2023** | **29 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT

International application No.

**PCT/JP2023/024674**

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2002-246608 A (SEMICONDUCTOR ENERGY LAB CO LTD) 30 August 2002 (2002-08-30)<br>paragraphs [0121]-[0128], fig. 3 | 19-20, 22, 24, 27-29 |

Form PCT/ISA/210 (second sheet) (January 2015)

**INTERNATIONAL SEARCH REPORT**
Information on patent family members

International application No.

**PCT/JP2023/024674**

| Patent document cited in search report | | | Publication date (day/month/year) | Patent family member(s) | | | Publication date (day/month/year) |
|---|---|---|---|---|---|---|---|
| WO | 2010/021280 | A1 | 25 February 2010 | US paragraphs [0067], [0121]-[0219], fig. 1, 12-40 | 2011/0150495 | A1 | |
| | | | | EP | 2326002 | A1 | |
| | | | | CN | 102124649 | A | |
| JP | 2011-109162 | A | 02 June 2011 | (Family: none) | | | |
| JP | 2014-182346 | A | 29 September 2014 | US paragraphs [0055]-[0056], fig. 5 | 2014/0285406 | A1 | |
| | | | | CN | 104064137 | A | |
| JP | 11-205693 | A | 30 July 1999 | (Family: none) | | | |
| JP | 2010-016672 | A | 21 January 2010 | (Family: none) | | | |
| JP | 2002-246608 | A | 30 August 2002 | US paragraphs [0161]-[0168], fig. 3 | 2002/0053671 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003133906 A